# EUROPEAN PATENT APPLICATION

(11) **EP 4 325 549 A1**
(43) Date of publication of application: **21.02.2024**
(21) Application number: 22788051.5
(22) Date of filing: 30.03.2022
(51) Int. Cl.: H01L 21/306

(54) **SUBSTRATE PROCESSING DEVICE, SUBSTRATE PROCESSING SYSTEM, AND DATA PROCESSING METHOD**

(30) Priority: 13.04.2021 JP 2021067672
(71) Applicant: SCREEN Holdings Co., Ltd., Kyoto-shi, Kyoto 602-8585 (JP)
(72) Inventor: OTA, Takashi, Kyoto-shi, Kyoto 602-8585 (JP); NAOHARA, Hideji, Kyoto-shi, Kyoto 602-8585 (JP); IKEUCHI, Takashi, Kyoto-shi, Kyoto 602-8585 (JP); HIRAOKA, Tetsuya, Kyoto-shi, Kyoto 602-8585 (JP)
(74) Representative: Kilian Kilian & Partner mbB
(86) International application number: PCT/JP2022/016051
(87) International publication number: WO 2022/220126

(57) **Abstract**

A substrate processing apparatus, a substrate processing system, and a data processing method are provided. A substrate processing apparatus (100) includes a thickness gauge (8), a controller (102), and storage (103). The thickness gauge (8) measures the thickness of an object (TG) included in a substrate (W). The controller (102) enters input data in a trained model (LM), thereby causing the trained model (LM) to output processing conditions. The storage (103) stores reference data (RE) acquired based on pieces of training data (LD) used to construct the trained model (LM). The controller (102) acquires pre-processing measurement data indicating the thickness of the object (TG) before the substrate processing is performed, and creates input data based on target data indicating a target value for the thickness of the object (TG) and the pre-processing measurement data. The controller (102) compares the input data and the reference data (RE) to determine whether or not to perform the substrate processing.

## Description

### TECHNICAL FIELD

The present invention relates to a substrate processing apparatus, a substrate processing system, and a data processing method.

### BACKGROUND ART

A substrate processing apparatus equipped with a trained model has been proposed (e.g., see Patent Literature 1). Such a substrate processing apparatus operates based on output data acquired from a trained model.

The substrate processing apparatus of Patent Literature 1 includes a discharge nozzle, a camera, and a controller. The camera captures images of the tip of the discharge nozzle and a processing liquid discharged from the tip. The camera captures the images while the processing liquid is being discharged onto a substrate and then acquires pieces of image data. The controller includes a machine-learned classifier (trained model). The classifier classifies image data into one of a plurality of categories (classes).

The categories are set according to respective discharge states of a processing liquid. Specifically, the plurality of categories includes: a category indicating a normal discharge state in which a processing liquid flows down as a continuous flow from the discharge nozzle; a dripping state in which a processing liquid drips down as droplets when the discharge of the processing liquid is stopped; and a category indicating a discharge stop state in which no processing liquid is being discharged.

The controller determines the discharge state of a processing liquid based on a classification result (output data) by the classifier. The controller notifies operators of an error when determining that a processing liquid is in a dripping state.

### CITATION LIST

### Patent Literature

Patent Literature 1: JP 2020-32409 A

### SUMMARY OF INVENTION

### Technical Problem

It is however difficult to guarantee the reliability of output data acquired from a trained model. That is, the output data from the trained model may not be optimal data. For example, non-optimal processing conditions (non-optimal set values) may be set when a trained model outputs processing conditions (set values) that are substrate processing conditions. If non-optimal processing conditions are set, the state of a substrate after substrate processing may differ from a target state. There is therefore room for further improvement in a substrate processing apparatus equipped with a trained model.

The present invention has been achieved in view of the above circumstances, and an object thereof is to provide a substrate processing apparatus, a substrate processing system, and data processing method, capable of assuring reliability of processing conditions acquired from a trained model.

### Solution to Problem

A substrate processing apparatus according to an aspect of the present invention performs substrate processing that is processing of a substrate. The substrate processing apparatus includes a thickness gauge, a controller, and storage. The thickness gauge measures the thickness of an object included in the substrate. The controller enters input data in a trained model which outputs processing conditions when the substrate processing is performed, thereby causing the trained model to output the processing conditions. The input data indicates a target value for a processing amount by the substrate processing. The storage stores reference data acquired based on pieces of training data used to construct the trained model. The training data indicates a processing amount by the substrate processing during training. The controller causes the thickness gauge to measure the thickness of the object before the substrate processing is performed and then acquires pre-processing measurement data indicating the thickness of the object before the substrate processing is performed. The controller creates the input data based on the pre-processing measurement data and target data indicating a target value for the thickness of the object. The controller compares the input data and the reference data to determine whether or not to perform the substrate processing.

In an embodiment, the storage stores at least one threshold for a comparison result between the input data and the reference data. The controller compares the input data and the reference data to acquire a comparison result, and then determines whether or not to perform the substrate processing based on the comparison result and the at least one threshold.

In an embodiment, the controller selects one of a plurality of determination items based on the comparison result and the at least one threshold. The plurality of determination items includes a first determination item, a second determination item, and a third determination item. The first determination item indicates determining not to perform the substrate processing. The second determination item indicates determining to perform the substrate processing based on the processing conditions acquired from the trained model, and also to cause the storage to store therein information indicating that the substrate processing has been performed. The third determination item indicates determining to perform the substrate processing based on the processing conditions acquired from the trained model.

In an embodiment, the at least one threshold includes a first threshold and a second threshold less than the first threshold. The controller selects the first determination item when the comparison result is greater than the first threshold. The controller selects the second determination item when the comparison result is greater than the second threshold and less than or equal to the first threshold. The controller selects the third determination item when the comparison result is equal to or less than the second threshold.

In an embodiment, the storage further stores predetermined conditions as the processing conditions. The plurality of determination items further includes a fourth determination item. The fourth determination item indicates determining to perform the substrate processing based on the predetermined conditions, and also to cause the storage to store therein information indicating that the substrate processing has been performed.

In an embodiment, the at least one threshold includes a first threshold and a second threshold less than the first threshold. The controller selects the first determination item when the comparison result is greater than the first threshold. The controller selects the second determination item or the fourth determination item when the comparison result is greater than the second threshold and less than or equal to the first threshold. The controller selects the third determination item when the comparison result is equal to or less than the second threshold.

In an embodiment, the substrate processing apparatus further comprises a display device that presents a setting screen. The setting screen includes a setting field that is allowed to set the at least one threshold in.

In an embodiment, the substrate processing apparatus further comprises a display device that presents a setting screen. The setting screen includes a first setting field that, for the at least one threshold, is allowed to set one determination item in. The one determination item is one of the plurality of determination items.

In an embodiment, the setting screen further includes a second setting field that is allowed to set the at least one threshold in.

In an embodiment, the setting screen further includes a graph display field that presents a graph in which the pieces of training data are quantified.

In an embodiment, the setting screen presents the at least one threshold in the graph display field.

In an embodiment, the substrate processing apparatus further comprises a nozzle that discharges a processing liquid toward the substrate. A process of the substrate processing includes a process of discharging the processing liquid from the nozzle toward the substrate.

In an embodiment, the substrate processing apparatus further comprises a nozzle-moving mechanism that cause the nozzle to move when the substrate processing is performed.

In an embodiment, the processing conditions include a moving speed of the nozzle.

In an embodiment, the processing liquid includes an etchant that etches the obj ect.

A substrate processing system according to an aspect of the present invention includes a thickness gauge apparatus and a substrate processing apparatus. The thickness gauge apparatus measures the thickness of an object included in a substrate. The substrate processing apparatus performs substrate processing, which is processing of the substrate, after the thickness gauge apparatus measures the thickness of the object. The substrate processing system includes a controller and storage. The controller enters input data in a trained model which outputs processing conditions when the substrate processing is performed, thereby causing the trained model to output the processing conditions. The input data indicates a target value for a processing amount by the substrate processing. The storage stores reference data acquired based on pieces of training data used to construct the trained model. The training data indicates a processing amount by the substrate processing during training. The controller acquires pre-processing measurement data from measurement results by the thickness gauge apparatus. The pre-processing measurement data indicates the thickness of the object before the substrate processing is performed. The controller creates the input data based on the pre-processing measurement data and target data indicating a target value for the thickness of the object. The controller compares the input data and the reference data to determine whether or not to perform the substrate processing.

A substrate processing system according to another aspect of the present invention includes a thickness gauge apparatus, a determining apparatus, and a substrate processing apparatus. The thickness gauge apparatus measures the thickness of an object included in a substrate. The determining apparatus determines whether or not to perform substrate processing, which is processing of the substrate. The substrate processing apparatus causes a trained model, which outputs processing conditions when the substrate processing is performed, to output the processing conditions to perform the substrate processing. The determining apparatus includes storage and a determining apparatus. The storage stores reference data acquired based on pieces of training data used to construct the trained model. The determining apparatus determines whether or not to perform the substrate processing. The training data indicates a processing amount by the substrate processing during training. The determining apparatus acquires pre-processing measurement data from measurement results by the thickness gauge apparatus. The pre-processing measurement data indicates the thickness of the object before the substrate processing is performed. The determining apparatus creates input data based on target data and the pre-processing measurement data. The input data indicates a target value for a processing amount by the substrate processing. The target data indicates a target value for the thickness of the object. The determining apparatus compares the input data and the reference data to determine whether or not to perform the substrate processing. The substrate processing apparatus includes a controller. When the determining apparatus determines to perform the substrate processing, the controller enters the input data in the trained model to cause the trained model to output the processing conditions.

A data processing method according to an aspect of the present invention includes: measuring the thickness of an object included in a substrate before substrate processing is performed to acquire pre-processing measurement data indicating measurement results of the thickness of the object; creating input data based on target data and the pre-processing measurement data, the input data indicating a target value for a processing amount by the substrate processing, the target data indicating a target value for the thickness of the object; and comparing reference data and the input data to determine whether or not to perform the substrate processing, the reference data being acquired based on pieces of training data used to construct a trained model. The training data indicates a processing amount by the substrate processing during training. The trained model outputs, in response to the input data being entered therein, processing conditions when the substrate processing is performed.

### Advantageous Effects of Invention

In the substrate processing apparatus, the substrate processing system, and the data processing method, according to an aspect of the present invention, it is possible to guarantee the reliability of the processing conditions acquired from the trained model.

### BRIEF DESCRIPTION OF DRAWINGS

[FIG. 1]

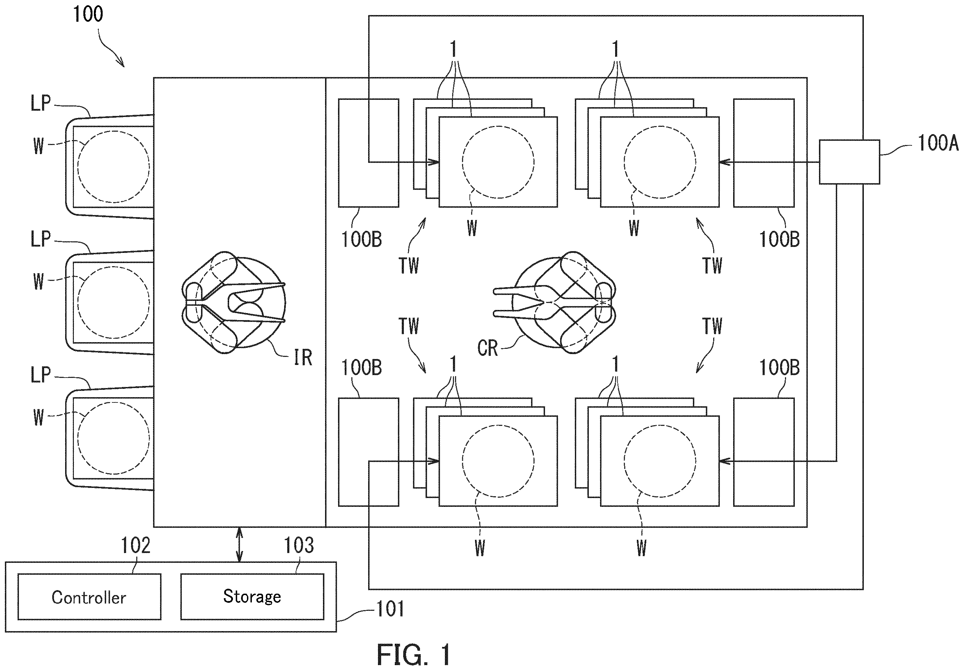

   FIG. 1 is a schematic diagram of a substrate processing apparatus in a first embodiment according to the present invention.
[FIG. 2]

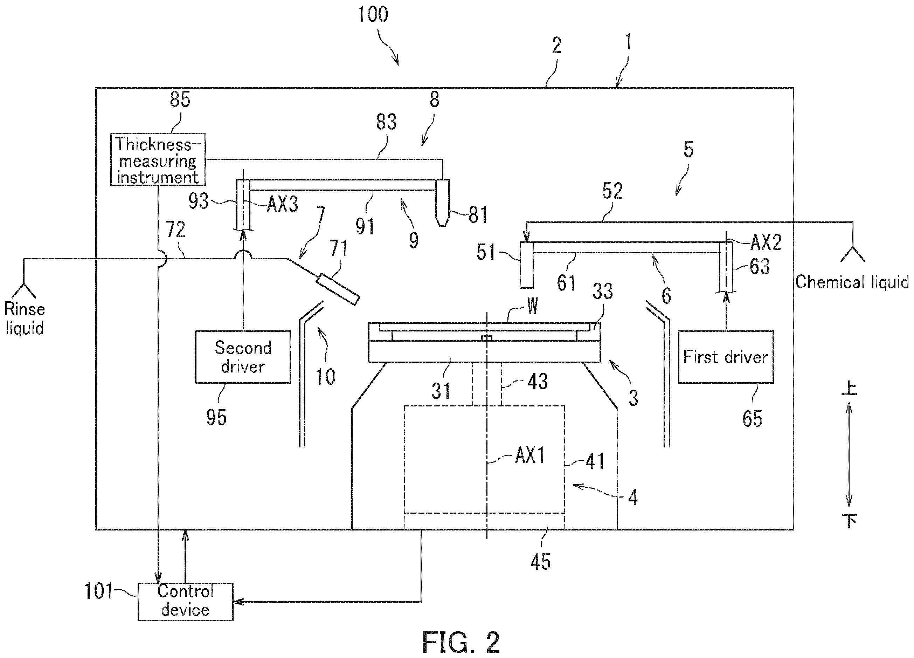

   FIG. 2 is a schematic diagram of a processing unit included in the substrate processing apparatus.
[FIG. 3]

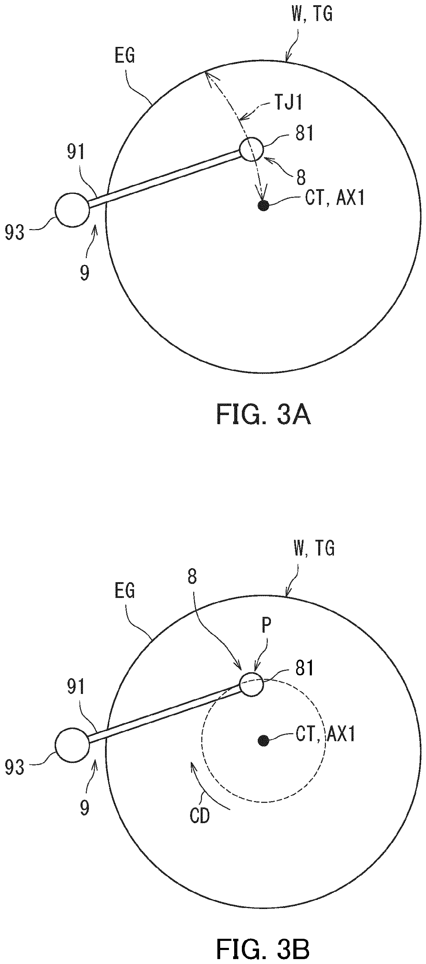

   FIG. 3A is a plan view depicting a probe-moving process, and FIG. 3B is a plan view depicting a thickness-measuring process.
[FIG. 4]

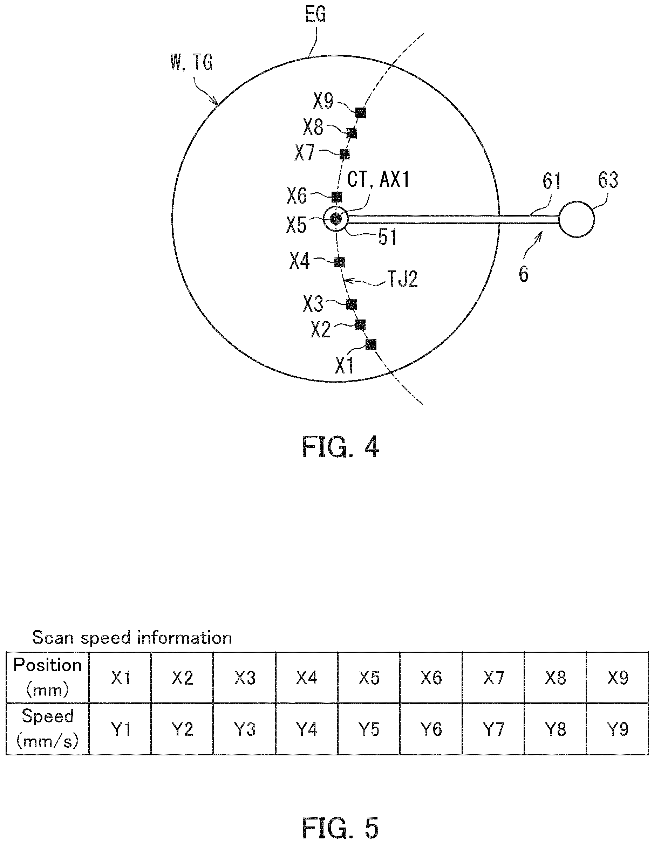

   FIG. 4 is a plan view depicting a scanning process of a substrate by a first nozzle.
[FIG. 5]
   FIG. 5 is a diagram depicting scan speed information.
[FIG. 6]

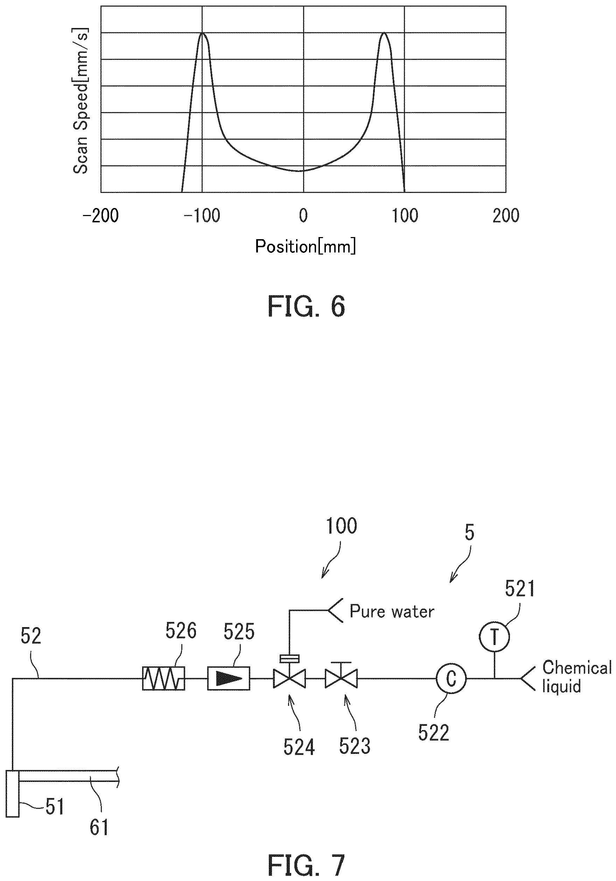

   FIG. 6 is a graph depicting an example of a moving speed of the first nozzle.
[FIG. 7]
   FIG. 7 is a schematic diagram of a chemical-liquid-supplying section.
[FIG. 8]

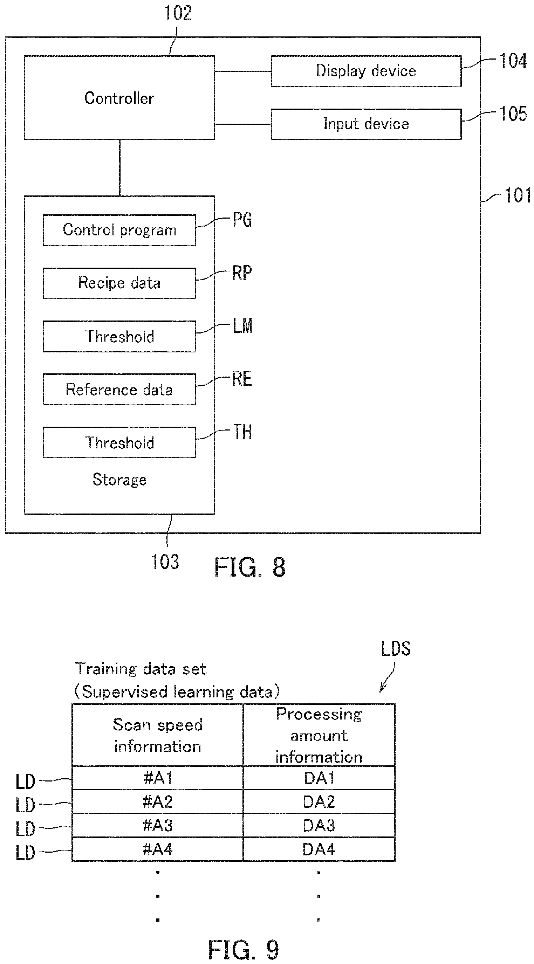

   FIG. 8 is a block diagram of a control device included in the substrate processing apparatus.
[FIG. 9]
   FIG. 9 is a diagram depicting a training data set used to construct reference data.
[FIG. 10]

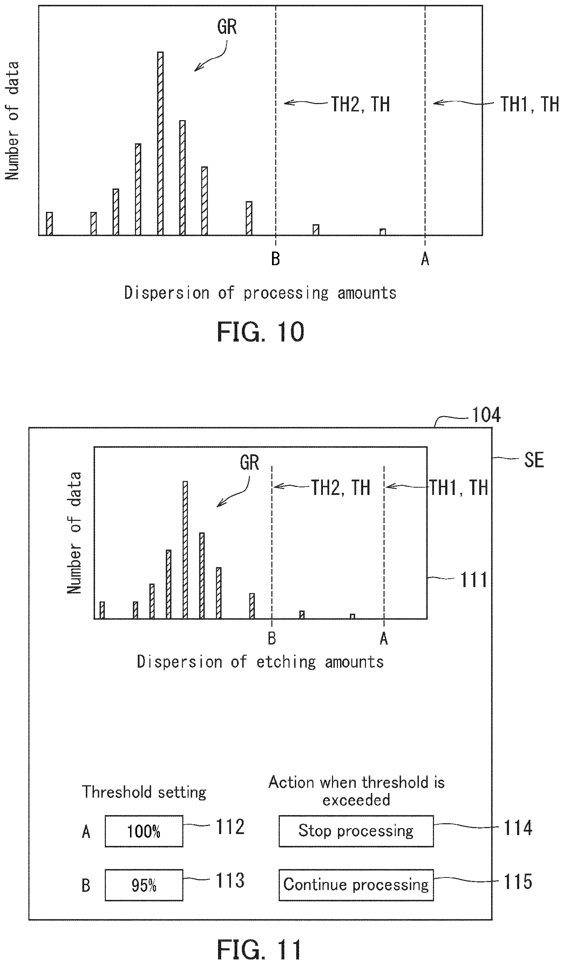

   FIG. 10 is a diagram depicting the relationship between thresholds and the variation in processing amounts contained in pieces of training data.
[FIG. 11]
   FIG. 11 is a diagram depicting a setting screen.
[FIG. 12]

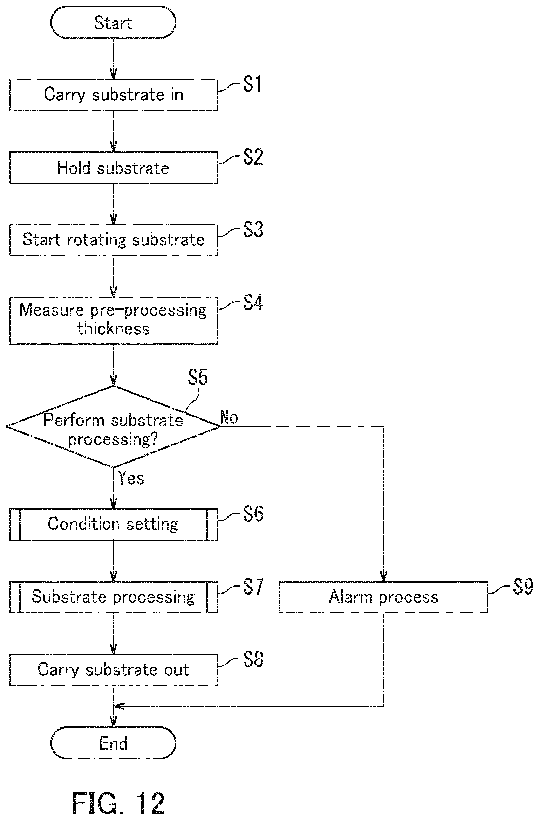

   FIG. 12 is a flow chart illustrating a process performed by the control device of the substrate processing apparatus.
[FIG. 13]

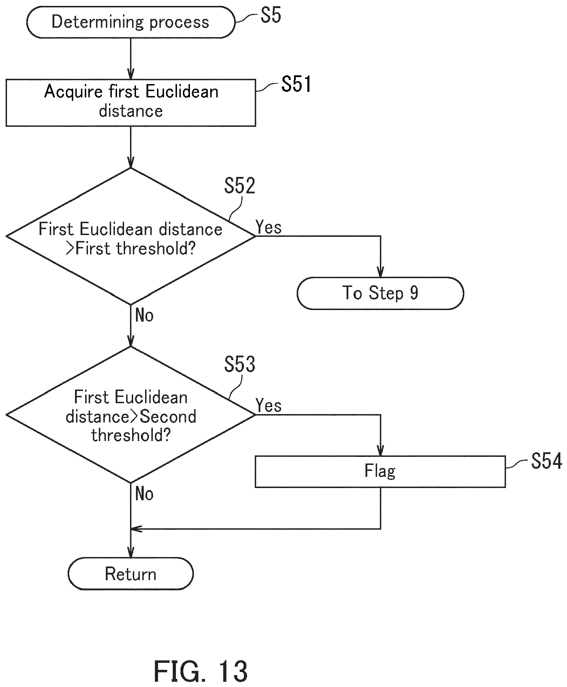

   FIG. 13 is a flow chart depicting a determining process.
[FIG. 14]

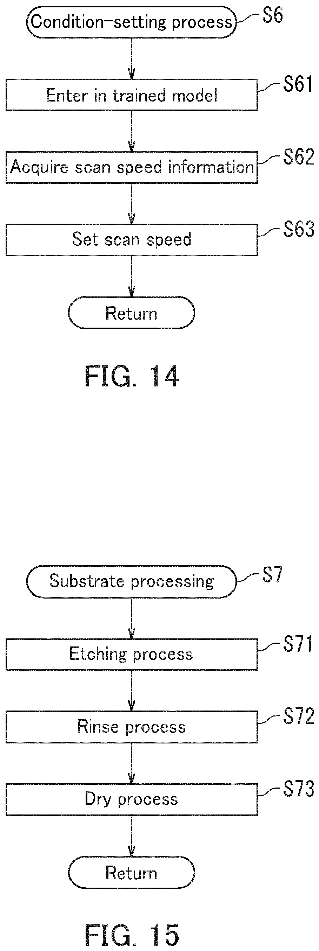

   FIG. 14 is a flow chart depicting a condition-setting process.
[FIG. 15]
   FIG. 15 is a flow chart depicting a process of substrate processing.
[FIG. 16]

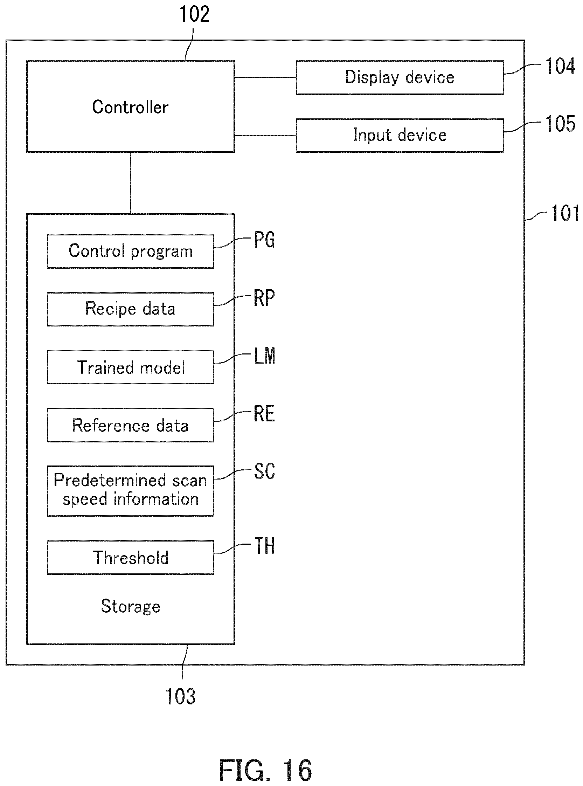

   FIG. 16 is a block diagram of a control device included in a substrate processing apparatus in a second embodiment according to the present invention.
[FIG. 17]

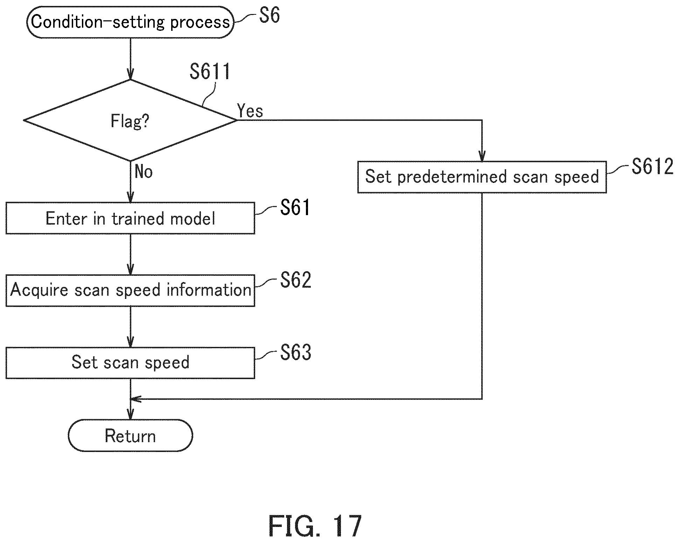

   FIG. 17 is a flow chart depicting a condition-setting process.
[FIG. 18]

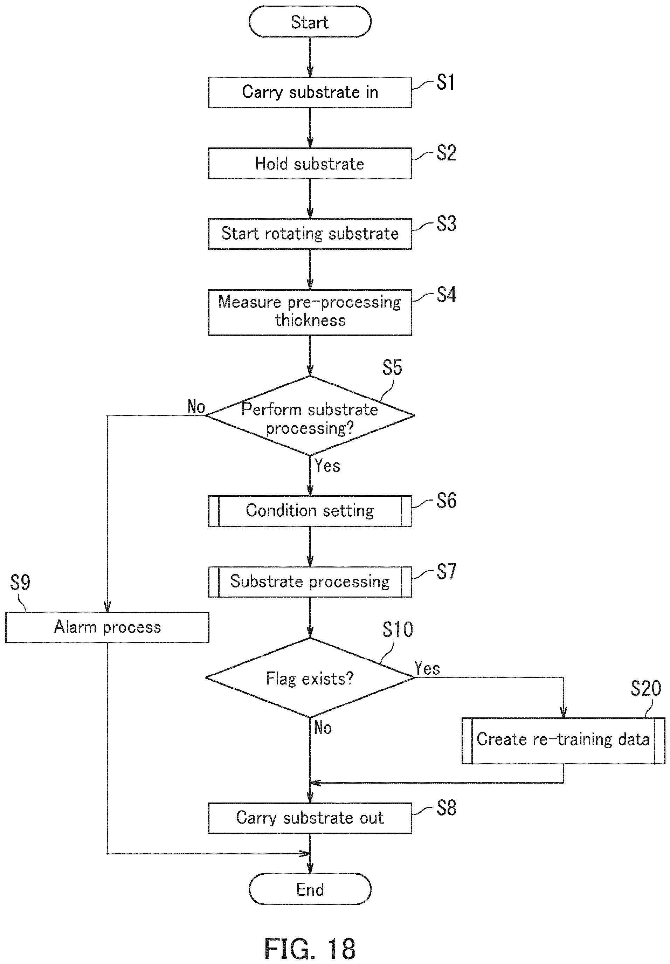

   FIG. 18 is a flow chart depicting a process to be performed by a control device of a substrate processing apparatus in a third embodiment according to the present invention.
[FIG. 19]

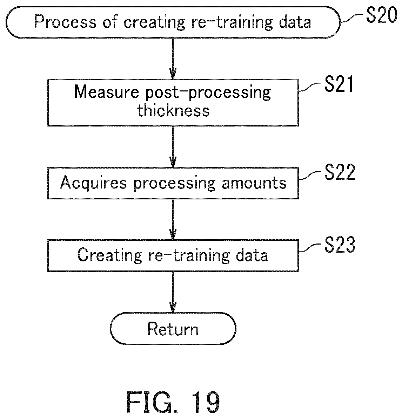

   FIG. 19 is a flow chart depicting a process of generating re-training data.
[FIG. 20]

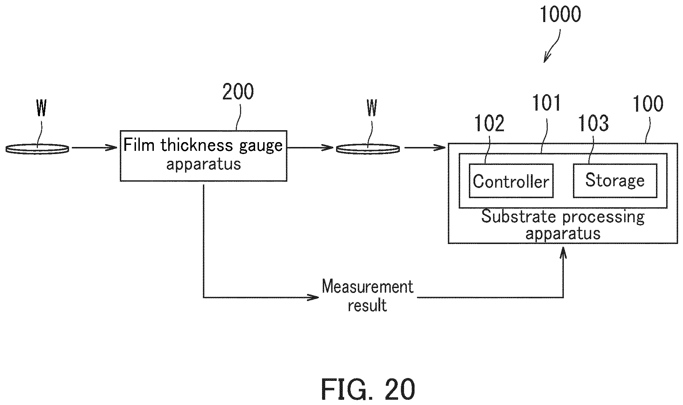

   FIG. 20 is a diagram depicting a substrate processing system in a fourth embodiment according to the present invention.
[FIG. 21]

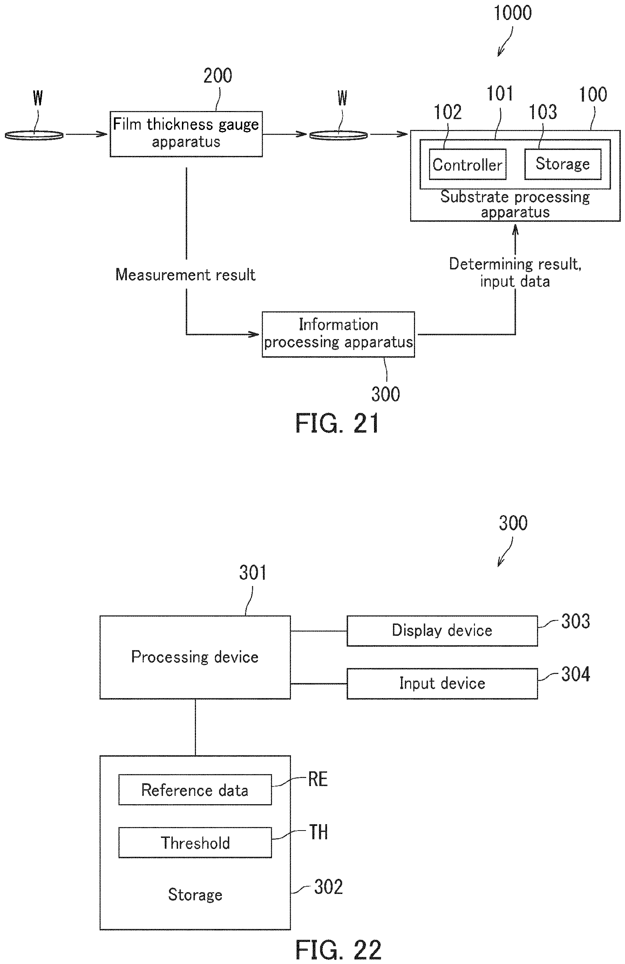

   FIG. 21 is a diagram depicting a substrate processing system in a fifth embodiment according to the present invention.
[FIG. 22]
   FIG. 22 is a block diagram depicting the configuration of an information processing apparatus.

### DESCRIPTION OF EMBODIMENTS

Embodiments according to a substrate processing apparatus, a substrate processing system, and a data processing method of the present invention will be described below with reference to the drawings (FIGS. 1 to 22). However, the present invention is not limited to the following embodiments, and can be implemented in various aspects without departing from the gist of the present invention. Note that overlapping description may be omitted as appropriate. The same or equivalent are labeled with the same reference signs in the drawings and description thereof is not repeated.

A "substrate" is an object of substrate processing in the substrate processing apparatus, substrate processing system, and data processing method according to the present invention. Applicable examples of the substrate include various substrates such as semiconductor wafers, photomask glass substrates, liquid crystal display glass substrates, plasma display glass substrates, field emission display (FED) substrates, optical disk substrates, magnetic disk substrates, and magneto-optical disk substrates. Hereinafter, the embodiments of the present invention will be described mainly by taking as an example a case where an object of substrate processing is a disk-shaped semiconductor wafer. The substrate processing apparatus, substrate processing system, and data processing according to the present invention can be similarly applied to various substrates other than the semiconductor wafer described above. In addition, the shape of the substrate is not limited to a disk shape, and the substrate processing apparatus, substrate processing system, and data processing method according to the present invention can be applied to substrates of various shapes.

### [First embodiment]

A first embodiment according to the present invention will be described below with reference to FIGS. 1 to 15. First, a substrate processing apparatus 100 in the present embodiment will be described with reference to FIG. 1. FIG. 1 is a schematic diagram of the substrate processing apparatus 100 in the present embodiment. Specifically, FIG. 1 is a schematic plan view of the substrate processing apparatus 100. More specifically, the substrate processing apparatus 100 is of a single-wafer processing type, and performs substrate processing for each substrate W. Substrate processing if processing of the substrate W.

As illustrated in FIG. 1, the substrate processing apparatus 100 includes a plurality of processing units 1, a fluid cabinet 100A, a plurality of fluid boxes 100B, a plurality of load ports LP, an indexer robot IR, a center robot CR, and a control device 101.

Each of the load ports LP accommodates a plurality of substrates W in a pile. For example, each load port LP accommodates substrates W after grinding processing. The indexer robot IR conveys each substrate W between each load port LP and the center robot CR. The center robot CR conveys each substrate W between the indexer robot IR and each processing unit 1. Note that as a device configuration, a mounting table (path) on which each substrate W is temporarily mounted may be provided between the indexer robot IR and the center robot CR. In the device configuration, each substrate W is indirectly conveyed between the indexer robot IR and the center robot CR via the mounting table.

The plurality of processing units 1 forms a plurality of towers TW (four towers TW in FIG. 1). The plurality of towers TW is arranged to surround the center robot CR in plan view. Each tower TW includes a plurality of processing units 1 (three processing units 1 in FIG. 1) stacked vertically.

The fluid cabinet 100A holds processing liquid. Each fluid box 100B corresponds to one of the plurality of towers TW. The processing liquid in the fluid cabinet 100A is supplied via one of the fluid boxes 100B to all the processing units 1 included in the tower TW corresponding to the fluid box 100B.

Each of the processing units 1 supplies the processing liquid onto the upper surface of each substrate W. The processing liquid includes a chemical liquid and a rinse liquid. In the present embodiment, each of the processing units 1 performs etching. The chemical liquid is an etchant. The upper surface of the substrate W is etched by the etchant. For example, each of the processing units 1 performs etching, thereby removing grinding traces generated by grinding.

Examples of the etchant include hydrofluoric/nitric acid (a mixture of hydrofluoric acid (HF) and nitric acid (HNO₃)), hydrofluoric acid, buffered hydrogen fluoride (BHF), ammonium fluoride, and a mixture of hydrofluoric acid and ethylene glycol (HFEG), and phosphoric acid (H₃PO₄). Examples of the rinse liquid include deionized water, carbonated water, electrolytic ionized water, hydrogen water, ozone water, and diluted hydrochloric acid water (for example, about 10 ppm to 100 ppm).

Next, the control device 101 will be described. The control device 101 controls the operation of each part of the substrate processing apparatus 100. For example, the control device 101 controls the load ports LP, the indexer robot IR, and the center robot CR. The control device 101 includes a controller 102 and storage 103.

The controller 102 includes a processor. Examples of the controller 102 include a central processing unit (CPU) and a micro processing unit (MPU). The examples of the controller 102 may further include a general-purpose calculator and a dedicated calculator. The controller 102 may further include a neural network processing unit (NCU).

The storage 103 stores data and computer programs. The data contains recipe data RP (see FIG. 8). The recipe data RP contains a recipe that defines the contents of substrate processing and the procedure of substrate processing. The recipe includes processing conditions (set values) when substrate processing is performed. The computer programs include a control program PG (see FIG. 8) and a trained model LM (see FIG. 8).

The storage 103 includes main memory. The main memory is, for example semiconductor memory. The storage 103 may further include an auxiliary storage device. Examples of the auxiliary storage include semiconductor memory and a hard disk drive. The storage 103 may include removable media. The controller 102 controls operations of each unit of the substrate processing apparatus 100 based on the computer programs and data stored in the storage 103.

The substrate processing apparatus 100 in the present embodiment will be further described with reference to FIGS. 1 and 2. FIG. 2 is a schematic diagram of each processing unit 1 included in the substrate processing apparatus 100. Specifically, FIG. 2 is a schematic cross-sectional view of each processing unit 1.

The processing unit 1 depicted in FIG. 1 includes a chamber 2, a spin chuck 3, a spin motor 4, a first nozzle 51, a nozzle-moving mechanism 6, a second nozzle 71, a thickness gauge 8, a probe-moving mechanism 9, and a plurality of guards 10 (in FIG. 2, two guards 10). The substrate processing apparatus 100 also includes a chemical-liquid-supplying section 5 and a rinse-liquid-supplying section 7. The chemical-liquid-supplying section 5 includes a first supply pipe 52. The rinse-liquid-supplying section 7 includes a second supply pipe 72. The control device 101 (controller 102) controls the spin chuck 3, the spin motor 4, the chemical-liquid-supplying section 5, the nozzle-moving mechanism 6, the rinse-liquid-supplying section 7, the thickness gauge 8, and the probe-moving mechanism 9.

The chamber 2 has a shape like a box. The chamber 2 accommodates the substrate W, the spin chuck 3, the spin motor 4, the first nozzle 51, part of the first supply pipe 52, the nozzle-moving mechanism 6, the second nozzle 71, part of the second supply pipe 72, the thickness gauge 8, the probe-moving mechanism 9, and the plurality of guards 10.

The spin chuck 3 holds the substrate W horizontally. The spin chuck 3 is an example of a substrate holder. Specifically, the spin chuck 3 includes a spin base 31 and a plurality of chuck members 33. The spin base 31 has a shape like a disc and supports the plurality of chuck members 33 in a horizontal posture. The plurality of chuck members 33 is arranged on the periphery of the spin base 31. The plurality of chuck members 33 supports the periphery of the substrate W. The plurality of chuck members 33 accordingly holds the substrate W in a horizontal posture.

The spin motor 4 integrally rotates the substrate W and the spin chuck 3 about the first rotation axis AX1. The first rotation axis AX1 extends in a vertical direction. In the present embodiment, the first rotation axis AX1 practically extends in a vertical direction. The first rotation axis AX1 is an example of a central axis, and the spin motor 4 is an example of a substrate-rotating section.

Specifically, the spin motor 4 rotates the spin base 31 about the first rotation axis AX1. The spin base 31 accordingly rotates about the first rotation axis AX1. As a result, the substrate W held by the spin chuck 3 rotates about the first rotation axis AX1.

Specifically, the spin motor 4 includes a motor body 41, a shaft 43, and an encoder 45. The shaft 43 is joined to the spin base 31. The motor body 41 rotates the shaft 43. As a result, the spin base 31 rotates.

The encoder 45 detects a rotational speed of the substrate W and transmits a signal to the control device 101 (controller 102). The signal indicates the rotational speed of the substrate W and is hereinafter referred to as a "rotational speed signal". Specifically, the encoder 45 measures the rotational speed of the motor body 41. The control device 101 (controller 102) controls the spin motor 4 based on the rotational speed signal.

The first nozzle 51 discharges a chemical liquid (etchant) toward the substrate W. In the present embodiment, a process of the substrate processing includes a discharge process of discharging the chemical liquid from the first nozzle 51 toward the substrate W. Specifically, the first nozzle 51 discharges the chemical liquid from a position above the substrate W toward the substrate W which is rotating. The first nozzle 51 is an example of a processing-liquid-supplying section. For example, the first nozzle 51 discharges an etchant toward the substrate W after the grinding process to flatten the upper surface of the substrate W after the grinding process.

More specifically, the chemical liquid is discharged toward an object TG (see FIGS. 3A and 3B) included in the substrate W. As a result, the substrate W is processed with the chemical liquid. The substrate processing apparatus 100 (each processing unit 1) in the present embodiment discharges an etchant onto the object TG to adjust the thickness of the object TG to a target thickness (a target thickness value).

Examples of the object TG include a substrate body (e.g., a substrate body made of silicon), a substance formed on the surface of the substrate body, and the substrate W. The substance formed on the surface of the substrate body is, for example, a substance of the same material as the substrate body (e.g., a layer made of silicon) or a substance of a material different from that of the substrate body (e.g., a silicon oxide film, a silicon nitride film, or a resist). The "substance" may constitute a membrane.

The chemical-liquid-supplying section 5 supplies a chemical liquid to the first nozzle 51. Specifically, the chemical liquid is supplied to the first nozzle 51 through the first supply pipe 52. The first supply pipe 52 is a tubular member that allows the chemical liquid to flow through.

The nozzle-moving mechanism 6 moves the first nozzle 51 when substrate processing is performed. Specifically, the nozzle-moving mechanism 6 moves the first nozzle 51 in the circumferential direction about a second rotation axis AX2 extending in the substantially vertical direction. The first nozzle 51 discharges a chemical liquid toward the substrate W while moving. The first nozzle 51 may be called a scan nozzle.

Specifically, the nozzle-moving mechanism 6 includes a nozzle arm 61, a first rotating shaft 63, and a first driver 65. The nozzle arm 61 practically extends in a horizontal direction. The first nozzle 51 is located at the tip of the nozzle arm 61. The nozzle arm 61 is joined to the first rotating shaft 63. The first rotating shaft 63 practically extends in a vertical direction.

The first driver 65 rotates the first rotating shaft 63 about the second rotation axis AX2 to turn the nozzle arm 61 about the first rotating shaft 63. As a result, the first nozzle 51 practically moves in a horizontal plane. Specifically, the first nozzle 51 moves around the first rotating shaft 63 in the circumferential direction about the second rotation axis AX2.

The first driver 65 transmits a rotational position signal to the control device 101 (controller 102). The rotational position signal indicates the rotational position of the first nozzle 51. For example, the first driver 65 includes a motor body and a Hall effect sensor. The Hall effect sensor detects the rotational position of the motor body. The control device 101 (controller 102) controls the first driver 65 based on the rotational position signal. The first driver 65 includes, for example a stepper motor. Alternatively, the first driver 65 may include a motor and a reduction drive.

The second nozzle 71 supplies a rinse liquid to a substrate W that is rotating from a position above the substrate W. The rinse-liquid-supplying section 7 supplies a rinse liquid to the second nozzle 71. Specifically, the rinse liquid is supplied to the second nozzle 71 via the second supply pipe 72. The second supply pipe 72 is a tubular member that allows the rinse liquid to flow through. The second nozzle 71 discharges the rinse liquid in a stationary state. The second nozzle 71 may be called a fixed nozzle. Note that the second nozzle 71 may be a scan nozzle.

Each of the guards 10 has a shape like a cylinder. Each guard 10 receives chemical and rinse liquids discharged from the substrate W.

The thickness gauge 8 measures the thickness of an object TG (see FIG. 3) included in a substrate W and generates a measurement signal indicating a measurement result. The thickness gauge 8 measures the thickness of the object TG in a non-contact manner. The measurement signal is entered in the control device 101 (controller 102).

The thickness gauge 8 measures the thickness of the object TG by interference spectroscopy, for example. Specifically, the thickness gauge 8 includes an optical probe 81, a signal line 83, and a thickness-measuring instrument 85.

The optical probe 81 includes a lens. The signal line 83 optically connects the optical probe 81 and the thickness-measuring instrument 85. Examples of the signal line 83 include an optical fiber. The thickness-measuring instrument 85 includes a light source and a photodetector.

The light source of the thickness-measuring instrument 85 emits light which is directed to a substrate W via the signal line 83 and the optical probe 81. The light is reflected by the substrate W and then received by the photodetector of the thickness-measuring instrument 85 via the optical probe 81 and the signal line 83.

The thickness-measuring instrument 85 analyzes the light received by the photodetector and calculates a value of the thickness of the object TG. The thickness-measuring instrument 85 generates a measurement signal indicating the calculated value of the thickness.

The probe-moving mechanism 9 moves the optical probe 81. Specifically, the probe-moving mechanism 9 practically moves the optical probe 81 in the circumferential direction around a third rotation axis AX3 in a vertical direction.

Specifically, the probe-moving mechanism 9 includes a probe arm 91, a second rotating shaft 93, and a second driver 95. The probe arm 91 practically extends in a horizontal direction. The optical probe 81 is located at the tip of the probe arm 91. The probe arm 91 is joined to the second rotating shaft 93. The second rotating shaft 93 practically extends in a vertical direction.

The second driver 95 rotates the second rotating shaft 93 about the third rotation axis AX3 to turn the probe arm 91 about the second rotating shaft 93. As a result, the optical probe 81 practically moves in a horizontal plane. Specifically, the optical probe 81 moves around the second rotating shaft 93 in the circumferential direction about the third rotation axis AX3.

The second driver 95 transmits a rotational position signal to the control device 101 (controller 102). The rotational position signal indicates the rotational position of the optical probe 81. For example, the second driver 95 includes a motor body and a Hall effect sensor. The Hall effect sensor detects the rotational position of the motor body. The control device 101 (controller 102) controls the second driver 95 based on the rotational position signal. Examples of the second driver 95 include a stepper motor. Alternatively, the second driver 95 may include a motor and a reduction drive.

A probe-moving process and a thickness-measuring process will now be described with reference to FIGS. 3A and 3B. The probe-moving process is a process of moving an optical probe 81 to a measurement position P. The measurement position P is a position where the thickness of an object TG is measured. FIG. 3A is a plan view depicting the probe-moving process. FIG. 3B is a plan view depicting the thickness-measuring process.

First, the probe-moving process will be described with reference to FIG. 3A. A controller 102 (see the description given with reference to FIG. 1) controls, before substrate processing is performed, a probe-moving mechanism 9 to move the optical probe 81 to the measurement position P. In the present embodiment, the probe-moving process is performed while a substrate W is rotating. Here, the probe-moving process may be performed before the substrate processing is performed. For example, the probe-moving process may be performed before the substrate W starts rotating.

As illustrated in FIG. 3A, the probe-moving mechanism 9 is configured to move the optical probe 81 along a track TJ1 having a shape like an arc in plan view. The track TJ1 passes through an edge portion EG of the substrate W and a central portion CT of the substrate W. The edge portion EG corresponds to the periphery of the substrate W. The central portion CT is a portion of the substrate W that a first rotation axis AX1 passes through. The probe-moving mechanism 9 moves the optical probe 81 along the track TJ1 to the measurement position P which is predetermined. The measurement position P is stored, in advance, in storage 103 (see the description given with reference to FIG. 1).

A thickness-measuring process will now be described with reference to FIG. 3B. The thickness-measuring process is performed before substrate processing is performed. Specifically, a controller 102 (see the description given with reference to FIG. 1) causes a thickness gauge 8 to measure the thickness of an object TG before the substrate processing is performed. As illustrated in FIG. 3B, an optical probe 81 is placed at a measurement position P when the thickness-measuring process is performed. In other words, the position of the optical probe 81 is fixed at the measurement position P when the thickness-measuring process is performed.

The thickness gauge 8 measures the thickness of the object TG at the measurement position P (fixed position). A substrate W is rotating when the thickness-measuring process is performed. The thickness gauge 8 accordingly measures the thickness of the object TG in a circumferential direction CD of the substrate W. Measurement signals therefore indicate the distribution of the thickness of the object TG in the circumferential direction CD of the substrate W.

The controller 102 (see the description given with reference to FIG. 1) acquires pre-processing measurement data based on the measurement signals. The pre-processing measurement data indicates the thickness of the object TG before the substrate processing is performed. More specifically, the pre-processing measurement data indicates the distribution of the thickness of the object TG.

A scanning process of a substrate W by a first nozzle 51 will now be described with referring to FIG. 4. FIG. 4 is a plan view depicting the scanning process of the substrate W by the first nozzle 51.

The scanning process is a process of causing the first nozzle 51 to discharge a chemical liquid to an object TG while moving such that positions where the chemical liquid lands on the surface of the object TG forms a track TJ2 having a shape like an arc in plan view as depicted in FIG. 4. The track TJ2 passes through a central portion CT of the substrate W. The scanning process is performed while the substrate W is rotating.

In the present embodiment, the first nozzle 51 discharges the chemical liquid toward the rotating substrate W while moving from a first position X1 to a ninth position X9. The positions X1 to X9 are included in the track TJ2.

The first position X1 is a discharge start position of the chemical liquid. The moving speed of the first nozzle 51 at the first position X1 is 0 mm/s. That is, the first position X1 is the start position of the scanning process. The first position X1 is also the movement start position of the first nozzle 51.

The ninth position X9 is a discharge stop position of the chemical liquid. The moving speed of the first nozzle 51 at the ninth position X9 is 0 mm/s. The ninth position X9 is the end position of the scanning process. The ninth position X9 is also the movement end position of the first nozzle 51.

The first nozzle 51 passes through intermediate positions between the first position X1 and the ninth position X9 during the scanning process. Here, the intermediate positions are positions X2 to X8 from the second position X2 to the eighth position X8. The intermediate positions divide, into a plurality of sections, a movement range in which the first nozzle 51 moves during the scanning process.

Scan speed information will now be described with reference to FIG. 5. The scan speed information indicates set values of the moving speed of a first nozzle 51 during the scan process. Hereinafter, the moving speed of the first nozzle 51 during the scanning process may be referred to as a "scan speed". FIG. 5 is a diagram depicting the scan speed information. Specifically, FIG. 5 depicts the relationship between positions X1 to X9 (see the description given with reference to FIG. 4) and the set values of the scan speed.

In FIG. 5, the upper column indicates the positions X1 to X9 included in a movement range of the first nozzle 51. Specifically, the upper column includes a start position, an end position, and intermediate positions, in a movement range of the first nozzle 51. The start position corresponds to a movement start position of the first nozzle 51. The end position corresponds to a movement end position of the first nozzle 51. The intermediate positions are between the start and end positions in the movement range of the first nozzle 51 and correspond to a plurality of positions through which the first nozzle 51 passes. The positions X1 to X9 are defined by radius positions of the substrate W.

In FIG. 5, the lower column indicates the set values of the scan speed. As illustrated in FIG. 5, the scan speed information indicates respective set values of scan speeds at the positions X1 to X9 included in the movement range of the first nozzle 51. Specifically, scan speeds Y1 to Y9 are set at the positions X1 to X9, respectively. Hereinafter, the positions X1 to X9 included in the movement range of the first nozzle 51 may be referred to as "speed-indicating positions". In the present embodiment, the scan speed information indicates speed-indicating positions at nine positions.

The speed-indicating positions depicted in FIG. 5 corresponds to the positions X1 to X9 described with reference to FIG. 4. Note that, as described with reference to FIG. 4, the scan speed Y1 set at the start position (first position X1) in the movement range of the first nozzle 51 is 0 [mm/s]. The scan speed Y9 set at the end position (the ninth position X9) in the movement range of the first nozzle 51 is also 0 [mm/s].

A controller 102 (see the description given with reference to FIG. 1) controls a first driver 65 of a nozzle-moving mechanism 6 (see the description given with reference to FIG. 2) based on the scan speed information. As a result, the first nozzle 51 moves along a track TJ2 (see the description given with reference to FIG. 4) such that respective scan speeds at the speed-indicating positions (positions X1 to X9) become the scan speeds (scan speeds Y1 to Y9) defined by the scan speed information.

The moving speed (scan speed) of the first nozzle 51 during the scanning process will be further described with referring to FIG. 6. FIG. 6 is a graph depicting an example of the moving speed of the first nozzle 51.

In FIG. 6, the vertical axis indicates scan speeds [mm/s] and the horizontal axis indicates radius positions of the substrate W [mm]. As illustrated in FIG. 6, the scan speed at the start in the scanning process is 0 [mm/s]. The scan speed at the end of the scanning process is also 0 [mm/s].

As described with reference to FIGS. 4 and 5, the scan speeds (scan speeds Y1 to Y9) are set for the speed-indicating positions (positions X1 to X9). As a result, the scan speed varies continuously as illustrated in FIG. 6 between adjacent speed-indicating positions from the scan speed that is set at one speed-indicating position to the scan speed that is set at another speed-indicating position.

For example, as illustrated in FIG. 5, the scan speed Y3 is set at the third position X3, and the scan speed Y4 is set at the fourth position X4. The scan speed of the first nozzle 51 therefore continuously varies from the scan speed Y3 to the scan speed Y4 while the first nozzle 51 moves from the third position X3 to the fourth position X4.

The chemical-liquid-supplying section 5 will be further described with reference to FIG. 7. FIG. 7 is a schematic diagram of the chemical-liquid-supplying section 5. As illustrated in FIG. 7, the chemical-liquid-supplying section 5 further include a temperature sensor 521, a concentration sensor 522, a valve 523, a mixing valve 524, a flowmeter 525, and a heater 526.

The temperature sensor 521 measures the temperature of a chemical liquid flowing through the first supply pipe 52. Hereinafter, the temperature of the chemical liquid flowing through the first supply pipe 52 is referred to as "chemical liquid temperature". The temperature sensor 521 generates a temperature signal indicating the chemical liquid temperature. The temperature signal is entered in the controller 102 described with reference to FIG. 1. The controller 102 controls the heater 526 based on the temperature signal. The heater 526 heats the chemical liquid flowing through the first supply pipe 52.

The concentration sensor 522 measures the concentration of etching components contained in the chemical liquid (etchant) flowing through the first supply pipe 52. Hereinafter, the concentration of the etching components contained in the chemical liquid flowing through the first supply pipe 52 is referred to as "chemical concentration". The concentration sensor 522 generates a concentration signal indicating the chemical concentration. The concentration signal is entered in the controller 102 described with reference to FIG. 1. The controller 102 controls the mixing valve 524 based on the concentration signal.

The valve 523 is placed in the first supply pipe 52. The valve 523 switches between allowing and stopping supply of the chemical liquid to the first nozzle 51. Specifically, when the valve 523 is opened, the chemical liquid is discharged from the first nozzle 51 toward a substrate W. On the other hand, when the valve 523 is closed, the discharge of the chemical liquid is stopped.

The valve 523 also controls the flow rate of the chemical liquid flowing downstream from the valve 523 in the first supply pipe 52. Specifically, the flow rate of the chemical liquid flowing downstream from the valve 523 is adjusted according to the opening degree of the valve 523. The discharge flow rate of the chemical liquid is therefore adjusted according to the opening degree of the valve 523. The valve 523 is, for example a motor valve.

The mixing valve 524 is placed in the first supply pipe 52. When the mixing valve 524 opens, pure water flows into the first supply pipe 52 to dilute the chemical liquid. The concentration of the chemical liquid is accordingly reduced.

The flowmeter 525 measures the discharge flow rate of the chemical liquid. Specifically, the flowmeter 525 measures the flow rate of the chemical liquid flowing through the first supply pipe 52. The flowmeter 525 generates a discharge flow rate signal indicating the discharge flow rate of the chemical liquid. The discharge flow rate signal is entered in the controller 102 described with reference to FIG. 1. The controller 102 controls the valve 523 based on the discharge flow rate signal.

The control device 101 will be further described with reference to FIG. 8. FIG. 8 is a block diagram of the control device 101 included in the substrate processing apparatus 100. As illustrated in FIG. 8, the control device 101 further includes a display device 104 and an input device 105.

The display device 104 presents various information. For example, the display device 104 presents various error screens and various setting screens (input screens). Examples of the display device 104 include a liquid crystal display and an organic electroluminescent (EL) display.

The input device 105 receives inputs from operators and outputs various information to the controller 102. Examples of the input device 105 include a keyboard, a pointing device, and a touch panel. For example, the touch panel may be placed on the display surface of the display device 104 and configure a graphical user interface together with the display device 104. This approach enables operators to operate the input device 105 to enter various processing conditions or various set values while the display device 104 presents a setting screen.

The controller 102 and the storage 103 will be further described with reference to FIG. 8. As illustrated in FIG. 8, the storage 103 stores a control program PG and recipe data RP. The recipe data RP includes various processing conditions when substrate processing is performed. Examples of the processing conditions in the recipe data RP include various set values such as moving speeds of the first nozzle 51 (respective scan speeds at speed-indicating positions), rotation speeds of a substrate W, chemical liquid temperature, chemical liquid concentration, and discharge flow rates of the chemical liquid. The controller 102 controls each part of the substrate processing apparatus 100 based on the control program PG and the recipe data RP.

For example, the controller 102 controls the first driver 65 described with reference to FIG. 2 so that the respective scan speeds at the speed-indicating positions match their respective set values. Similarly, the controller 102 controls the motor body 41 described with reference to FIG. 2 so that the rotation speed of the substrate W matches the set value thereof. The controller 102 controls the heater 526 described with reference to FIG. 7 so that the chemical liquid temperature matches the set value thereof. The controller 102 controls the mixing valve 524 described with reference to FIG. 7 so that the chemical liquid concentration matches the set value thereof. The controller 102 controls the valve 523 described with reference to FIG. 7 so that the discharge flow rates of the chemical liquid match the set values thereof.

The storage 103 further stores the trained model LM. The trained model LM outputs, based on input data, processing conditions when substrate processing is performed. Before starting the substrate processing, the controller 102 sets, in the recipe data RP, the processing conditions acquired from the trained model LM.

In the present embodiment, the trained model LM outputs scan speed information based on input data. Before starting substrate processing, the controller 102 enters the input data to the trained model LM, thereby causing the trained model LM to output the scan speed information. The controller 102 then sets the moving speeds of the first nozzle 51 (respective scan speeds at speed-indicating positions) in the recipe data RP based on the scan speed information acquired from the trained model LM. The scan speed information acquired from the trained model LM is objective variables.

Specifically, the controller 102 generates input data indicating target values for processing amounts by the substrate processing. The target values for the processing amounts to be entered in the trained model LM are explanatory variables. In the present embodiment, the target values for the processing amounts are the target values for etching amounts. The target values for etching amounts indicate the etching amount distribution required to match the thickness of an object TG to target thickness. The controller 102 creates input data based on pre-processing measurement data and target data. The pre-processing measurement data indicates the distribution of the thickness of the object TG before the substrate processing is performed. The target data indicates a target value for the thickness of the object TG (target thickness). Specifically, the input data indicates the difference between the distribution of the thickness of the object TG before the substrate processing is performed and the target thickness.

Hereinafter, the thickness of the object TG before the substrate processing is performed may also be referred to as "pre-processing thickness". On the other hand, the thickness of the object TG after the substrate processing is performed may also be referred to as "post-processing thickness".

The storage 103 further stores reference data RE. The reference data RE is acquired based on pieces of training data LD used to build the trained model LM. The trained model LM is constructed by machine-learning the pieces of training data LD.

A machine learning algorithm for constructing the trained model LM is not particularly limited as long as it is supervised learning. Examples of the algorithm include decision trees, nearest neighbour algorithms, naive Bayes classifiers, support vector machines, and artificial neural networks. The trained model LM therefore include a decision tree, a nearest neighbour algorithm, a naive Bayes classifier, a support vector machine, or an artificial neural network. Backpropagation may be used for machine learning.

For example, the artificial neural network includes an input layer, one or more hidden layers, and an output layer. Specific examples of the artificial neural network include a deep neural network (DNN), a recurrent neural network (RNN), and a convolutional neural network (CNN). The artificial neural network accordingly performs deep learning. For example, the deep neural network includes an input layer, multiple hidden layers, and an output layer.

The controller 102 performs a determining process based on the input data and the reference data RE. The determining process is a process for determining whether or not to perform substrate processing. Specifically, the controller 102 compares the input data and the reference data RE to determine whether or not to perform the substrate processing.

If determining to perform the substrate processing, the controller 102 enters the input data in the trained model LM. The controller 102 then sets the moving speeds of the first nozzle 51 (scan speeds at speed-indicating positions) in the recipe data RP based on the scan speed information acquired from the trained model LM. The controller 102 subsequently controls a processing unit 1 to cause the processing unit 1 to perform the substrate processing.

If determining not to perform the substrate processing, the controller 102 stops the processing unit 1 from performing the substrate processing without entering the input data in the trained model LM. The controller 102 then causes the display device 104 to present an error screen. The error screen is a screen that informs operators that an error has occurred.

The reference data RE will be further described with reference to FIG. 9. FIG. 9 is a diagram depicting a training data set LDS used to construct the reference data RE. As illustrated in FIG. 9, the training data set LDS includes multiple pieces of training data LD.

Each piece of training data LD contains scan speed information and processing amount information. The scan speed information and the processing amount information are associated with each other. FIG. 9 depicts pieces of processing amount information DA1 to DA4 associated with pieces of scan speed information #A1 to #A4, respectively. The training data LD is created by performing substrate processing with respect to a substrate as a learning target. Hereinafter, the substrate as the learning target may be referred to as a "learning target substrate".

The scan speed information contains scan speeds at speed-indicating positions that are set when substrate processing is performed on the learning target substrate. The processing amount information indicates a processing amount by substrate processing during training. Specifically, the processing amount indicates the difference between pre-processing thickness and post-processing thickness of the learning target substrate. In the present embodiment, the processing amount is an etching amount. Specifically, the processing amount information indicates the difference between the distribution of pre-processing thickness and the distribution of post-processing thickness of the learning target substrate. The processing amount information therefore indicates the distribution of etching amount by the etching process during training.

The reference data RE is acquired based on the processing amount information of each training data LD. For example, the reference data RE may be an average value of processing amounts contained in pieces of training data LD. Alternatively, the reference data RE may be selected from processing amounts contained in pieces of training data LD. The reference data RE may be created by an operator based on the processing amounts contained in pieces of training data LD.

As described above with reference to FIGS. 1 to 9, the controller 102 determines whether or not to perform substrate processing by comparing reference data (reference data RE) acquired based on a processing amount by substrate processing during training and a target value for the processing amount. It is therefore possible to guarantee the reliability of the processing conditions acquired from the trained model LM.

For example, if input data, namely the target value for the processing amount corresponds to the processing amount that has not been acquired during training, processing conditions that are not optimal may be acquired as unexpected processing conditions from the trained model LM. In contrast, the controller 102 in the present embodiment can determine not to perform the substrate processing when the target value for the processing amount as the input data corresponds to a processing amount that has not been acquired during training. It is therefore possible to prevent non-optimal processing conditions from being acquired as unexpected processing conditions from the trained model LM. The controller 102 can also determine to perform the substrate processing if the target value for the processing amount as the input data corresponds to the processing amount acquired during training. In this case, it is unlikely that non-optimal processing conditions will be acquired as unexpected processing conditions from the trained model LM. It is therefore possible to guarantee the reliability of the processing conditions acquired from the trained model LM.

Note that training data LD may further include information indicating that the processing amount (etching amount) does not match the target processing amount (target etching amount), or information indicating that the processing amount is not within an allowable range.

A determining process to be performed by a controller 102 will now be described with reference to FIG. 8. As illustrated in FIG. 8, storage 103 further stores a threshold TH. The threshold TH is a threshold for a comparison result between input data and reference data RE. The controller 102 compares the input data and the reference data RE to acquire the comparison result and then determines whether or not to perform substrate processing based on the comparison result and the threshold TH.

In the present embodiment, the threshold TH is a threshold for a Euclidean distance between the reference data RE and input data. The controller 102 calculates a Euclidean distance between the reference data RE and input data. The controller 102 then compares the Euclidean distance calculated and the threshold TH. If the Euclidean distance is greater than the threshold TH, the controller 102 determines not to perform the substrate processing. If the Euclidean distance is equal to or less than the threshold TH, the controller 102 determines to perform the substrate processing. Hereinafter, a Euclidean distance between the reference data RE and input data may be referred to as a "first Euclidean distance".

More specifically, the reference data RE is normalized. The controller 102 normalizes input data and calculates a Euclidean distance (first Euclidean distance) between the reference data RE and the input data normalized. The reference data RE normalized can be acquired by normalizing respective processing amounts of pieces of training data LD by an average value or a minimum value thereof. Similarly, the controller 102 acquires an average value or a minimum value of the input data and then normalizes the input data by the average value or the minimum value.

In the present embodiment, it is possible to determine whether or not to perform the substrate processing using the threshold TH. This approach makes it possible to easily determine whether or not to perform the substrate processing.

A determining process to be performed by a controller 102 will now be described with reference to FIGS. 8 and 10. FIG. 10 is a diagram depicting the relationship between dispersion of processing amounts included in pieces of training data LD and thresholds TH.

In FIG. 10, the horizontal axis indicates Euclidean distance. The vertical axis indicates the number of training data LD corresponding to each Euclidean distance in the horizontal axis. A graph GR represents the dispersion of the processing amounts included in the pieces of training data LD.

The graph GR is created by normalizing respective processing amounts of the pieces of training data LD and calculating a Euclidean distance between reference data RE normalized and the processing amounts, of the pieces of training data LD, normalized. Hereinafter, the Euclidean distance between processing amounts of training data LD and the reference data RE may be referred to as a "second Euclidean distance".

In the present embodiment, the thresholds TH include a first threshold TH1 and a second threshold TH2. The controller 102 compares input data and the reference data RE to acquire a comparison result, and selects one of determination items based on the comparison result and the thresholds TH (first threshold TH1 and second threshold TH2).

The determination items includes first to third determination items. The first determination item indicates determining not to perform substrate processing. The second determination item indicates determining to perform substrate processing based on processing conditions acquired from a trained model LM and to store, in storage 103, flag information indicating that the substrate processing has been performed. The third determination item indicates determining to perform the substrate processing based on the processing conditions acquired from the trained model LM. Note that in the third determination item, flag information indicating that the substrate processing has been performed is not given.

As illustrated in FIG. 10, a value A of the first threshold TH1 is set to a value larger than the maximum value of the second Euclidean distance. That is, the first threshold TH1 corresponds to processing amounts that are not included in processing amounts of the pieces of training data LD. In other words, the first threshold TH1 corresponds to processing amounts that have not been acquired during training. Therefore, when the first Euclidean distance is greater than the first threshold TH1, there is a high possibility that the trained model LM outputs unexpected processing conditions if input data is entered in the trained model LM.

In the present embodiment, if the first Euclidean distance is greater than the first threshold TH1, the controller 102 selects the first determination item, thereby determining not to perform substrate processing. Input data is accordingly not entered in the trained model LM when there is a possibility that processing conditions to be acquired from the trained model LM are not optimal. The trained model LM can therefore be prevented from outputting processing conditions whose reliability cannot be guaranteed. It is thus possible to guarantee the reliability of processing conditions acquired from the trained model LM.

As illustrated in FIG. 10, a value B of the second threshold TH2 is set to a value in a region where the number of training data is small. The region where the number of training data is small corresponds to a region where most of processing amounts are not acquired during training. There is a slight possibility that optimal processing conditions will not be acquired from the trained model LM when a processing amount of input data is included in the region where most of processing amounts are not acquired during training. That is, there is a slight possibility that the trained model LM will output non-optimal processing conditions (unexpected processing conditions) if input data is entered in the trained model LM when a first Euclidean distance is less than or equal to the first threshold TH1 and greater than the second threshold TH2. In other words, the reliability of the processing conditions acquired from the trained model LM is slightly low.

If the first Euclidean distance is equal to or less than the first threshold TH1 and greater than the second threshold TH2, the controller 102 selects the second determination item, thereby determining to perform substrate processing based on processing conditions acquired from the trained model LM and to store, in the storage 103, flag information indicating that the substrate processing has been performed. Therefore, when the thickness or upper surface state of an object TG included in a substrate W after the substrate processing is different from an expected thickness or expected state, the operator can verify the cause.

Note that if a Euclidean distance is equal to or less than the second threshold TH2, the controller 102 selects the third determination item, thereby determining to perform substrate processing based on the processing conditions acquired from the trained model LM. In this case, the storage 103 does not store flag information indicating that the substrate processing has been performed.

A setting screen SE will be described with reference to FIGS. 8 and 11. FIG. 11 is a diagram depicting the setting screen SE. As illustrated in FIG. 11, a display device 104 presents the setting screen SE. The setting screen SE includes a graph display field 111 and first to fourth setting fields 112 to 115.

The first setting field 112 is an input field that allows an operator to operate an input device 105, thereby entering therein a value A of the first threshold TH1. The second setting field 113 is an input field that allows an operator to operate the input device 105, thereby entering therein a value B of the second threshold TH2. Note that FIG. 11 depicts a case where the numerical values to be entered in the first and second setting fields 112 and 113 are displayed as percentages. Specifically, the first and second setting fields 112 and 113 present percentages corresponding to values obtained by converting a Euclidean distance from the reference data RE into a mean square deviation.

The third setting field 114 is an input field that allows an operator to enter therein an operation to be performed by a substrate processing apparatus 100 when a first Euclidean distance is greater than the first threshold TH1. In other words, the third setting field 114 is an input field that allows an operator to enter therein a determination item to be selected by the controller 102 when the first Euclidean distance is greater than the first threshold TH1. "Stop processing" depicted in FIG. 11 corresponds to the first determination item.

The fourth setting field 115 is an input field that allows an operator to enter therein an operation to be performed by the substrate processing apparatus 100 when a first Euclidean distance is greater than the second threshold TH2 and less than or equal to the first threshold TH1. In other words, the fourth setting field 115 is an input field that allows an operator to enter therein a determination item to be selected by the controller 102 when the first Euclidean distance is greater than the second threshold TH2 and less than or equal to the first threshold TH1. "Continue processing" depicted in FIG. 11 corresponds to the second determination item.

The graph display field 111 presents a graph GR, a horizontal axis, and a vertical axis. In the present embodiment, the graph GR depicts dispersion in etching amount. The horizontal axis indicates Euclidean distance. The vertical axis indicates the number of training data LD corresponding to each Euclidean distance in the horizontal axis. In the present embodiment, the graph display field 111 further presents a first threshold TH1 and a second threshold TH2 that are entered in the first setting field 112 and the second setting field 113, respectively.

The approach by the present embodiment enables users to set respective values of the thresholds TH (value A of first threshold TH1 and value B of second threshold TH2) to arbitrary values. User convenience is therefore improved.

The approach also enables users to arbitrarily set operations to be performed by the substrate processing apparatus 100 when a first Euclidean distance exceeds a value of a threshold TH (value A of first threshold TH1 or value B of second threshold TH2). User convenience is therefore improved.

The graph display field 111 presenting the graph GR makes it easier for users to determine respective values of the thresholds TH. Similarly, the graph display field 111 presenting the graph GR makes it easier for users to determine an operation to be performed by the substrate processing apparatus 100 when the first Euclidean distance exceeds a value of a threshold TH (value A of first threshold TH1 or value B of second threshold TH2).

In addition, first and second thresholds TH1 and TH2 entered in the first and second setting fields 112 and 113 are displayed together with the graph GR, thereby making it easier for users to determine respective values of the thresholds TH.

Note that the graph display field 111 may be omitted.

A process to be performed by a control device 101 (controller 102) of a substrate processing apparatus 100 will now be described with reference to FIGS. 1 to 12. FIG. 12 is a flow chart depicting the process to be performed by the control device 101 (controller 102) of the substrate processing apparatus 100. Specifically, the process depicted in FIG. 12 is to be performed by the controller 102 when substrate processing is performed on a single substrate W. The process to be performed by controller 102 includes Steps S1 to S9, as illustrated in FIG. 12. Note that of Steps S1 to S9, Steps S4 and S5 are included in a data processing method.

When an operator operates an input device 105 to enter an instruction to start an etching process of the substrate W, the process depicted in FIG. 12 starts. That is, when the operator operates the input device 105 to instruct the controller 102 to start the etching process of the substrate W, the controller 102 controls an indexer robot IR and a center robot CR to load a substrate W into a chamber 2 of a processing unit 1 (Step S1). The substrate W loaded is held by a spin chuck 3 (Step S2).

When the spin chuck 3 holds the substrate W, the controller 102 controls a spin motor 4 to start rotating the substrate W (Step S3). Specifically, the spin motor 4 rotates the substrate W integrally with the spin chuck 3.

When rotating speed of the substrate W is stabilized at a predetermined rotating speed, the controller 102 controls a thickness gauge 8 to causes the thickness gauge 8 to measure the thickness (pre-processing thickness) of an object TG included in the substrate W (Step S4).

Specifically, as described with reference to FIG. 3A, the controller 102 controls a probe-moving mechanism 9 to move an optical probe 81 to a measurement position P (probe-moving process). The controller 102 then causes the thickness gauge 8 to measure the thickness of the object TG (thickness-measuring process). The controller 102 acquires pre-processing measurement data based on measurement signals acquired from a thickness-measuring instrument 85 of the thickness gauge 8. The pre-processing measurement data indicates the distribution of the thickness (pre-processing thickness) of the object TG before the substrate processing is performed.

The controller 102 acquires the pre-processing measurement data and subsequently performs a determining process (see the description given with reference to FIGS. 8 to 11) to determine whether or not to perform the substrate processing (Step S5).

If determining to perform the substrate processing (Yes in Step S5), the controller 102 enters input data in a trained model LM to acquire scan speed information (processing conditions). The controller 102 then sets, in recipe data RP, respective scan speeds at speed-indicating positions based on the scan speed information acquired from the trained model LM (Step S6).

The controller 102 sets the scan speeds at the speed-indicating positions in the recipe data RP and subsequently performs the substrate processing (Step S7). Specifically, the controller 102 performs a scanning process (see the description given with reference to FIG. 4). That is, the controller 102 controls a chemical-liquid-supplying section 5 to cause a first nozzle 51 to discharge a chemical liquid toward the substrate W while controlling a nozzle-moving mechanism 6 to move the first nozzle 51.

After performing the substrate processing, the controller 102 releases the holding of the substrate W by the spin chuck 3. The controller 102 then controls the center robot CR to unload the substrate W from the chamber 2 of the processing unit 1 (Step S8). The controller 102 also controls the center robot CR and the indexer robot IR to convey the substrate W unloaded from the chamber 2 of the processing unit 1 to one of a plurality of load ports LP. The process depicted in FIG. 12 then ends.

If determining not to perform substrate processing (No in Step S5), the controller 102 performs an alarm process (step S9) and then ends the process depicted in FIG. 12. The alarm process is a process for notifying that an error has occurred in the substrate processing apparatus 100. For example, the controller 102 causes a display device 104 to present an error screen, thereby notifying that an error has occurred in the substrate processing apparatus 100.

A determining process (Step S5) will now be described with reference to FIGS. 1 to 13. FIG. 13 is a flow chart depicting the determining process (Step S5). The determining process (Step S5) includes Steps S51 to S54 as illustrated in FIG. 13.

A controller 102 starts the determining process (Step S5). The controller 102 then creates input data based on pre-processing measurement data (pre-processing thickness) and target data (target thickness) and acquires a Euclidean distance (first Euclidean distance) between reference data RE and the input data (Step S51).

The controller 102 acquires the first Euclidean distance and then determines whether or not the first Euclidean distance is greater than a first threshold TH1 (Step S52). If determining that the first Euclidean distance is greater than the first threshold TH1 (Yes in Step S52), the controller 102 determines not to perform substrate processing. The determining process (Step S5) then ends and a process step to be performed by the controller 102 proceeds to Step S9 (see the description given with reference to FIG. 12).

If determining that the first Euclidean distance is not greater than the first threshold TH1 (No in Step S52), the controller 102 determines whether or not the first Euclidean distance is greater than a second threshold TH2 (Step S53).

If determining that the first Euclidean distance is greater than the second threshold TH2 (Yes in Step S53), the controller 102 causes storage 103 to store flag information indicating that the substrate processing has been performed. The determining process (Step S5) then ends and a process step to be performed by the controller 102 proceeds to Step S6 (see the description given with reference to FIG. 12).

If determining that the first Euclidean distance is not greater than the second threshold TH2 (No in Step S53), the controller 102 ends the determining process (step S5) and a process step to be performed by the controller 102 proceeds to Step S6 (see the description given with reference to FIG. 12).

A condition-setting process (Step S6) will now be described with reference to FIGS. 1 to 14. FIG. 14 is a flow chart depicting the condition-setting process (Step S6). The condition-setting process (Step S6) includes Steps S61 to S63 as illustrated in FIG. 14.

The controller 102 starts the condition-setting processing (Step S6) and then enters input data in a trained model LM (Step S6), so that the trained model LM outputs scan speed information (processing conditions). The controller 102 then acquires the scan speed information (Step S62). The controller 102 sets, in recipe data RP, respective scan speeds at speed-indicating positions based on the scan speed information acquired from the trained model LM (Step S63). The condition-setting process (Step S6) then ends and a process step to be performed by the controller 102 proceeds to Step S7 (see the description given with reference to FIG. 12).

A process of substrate processing (Step S7) will now be described with reference to FIGS. 1 to 15. FIG. 15 is a flow chart depicting the process of substrate processing (Step S7). The process of substrate processing (step S7) includes Steps S71 to S73 as illustrated in FIG. 15.

A controller 102 starts the process of substrate processing (Step S7). The controller 102 then controls a chemical-liquid-supplying section 5 and a nozzle-moving mechanism 6 to cause a first nozzle 51 to discharge etchant toward a substrate W while moving the first nozzle 51 (Step S71). As a result, the substrate W is etched (etching process).

When the etching of the substrate W is completed, the controller 102 controls a rinse-liquid-supplying section 7 to cause a second nozzle 71 to discharge a rinse liquid toward the substrate W (Step S72). As a result, the etchant is removed from the substrate W. Specifically, the etchant is washed away from the substrate W by the rinse liquid and discharged to the surroundings of the substrate W. A liquid film of the etchant on the substrate W is therefore replaced with a liquid film of the rinse liquid.

After the etchant is replaced with the rinse liquid, the controller 102 controls a spin motor 4 to dry the substrate W (Step S73). The process of substrate processing (Step S7) then ends and a process step to be performed by the controller 102 proceeds to Step S8 (see the description given with reference to FIG. 12).

Specifically, the controller 102 increases the rotation speed of the substrate W more than the rotation speed during etching and rinsing. As a result, a large centrifugal force is applied to the rinse liquid on the substrate W and the rinse liquid onto the substrate W is shaken off around the substrate W. Thus, the rinse liquid is removed from the substrate W and the substrate W is dried. Note that the controller 102 stops the rotation of the substrate W by the spin motor 4, for example, after a predetermined time has elapsed since the high-speed rotation of the substrate W was started.

The first embodiment of the present invention has been described above with reference to FIGS. 1 to 15. The approach of the present embodiment enables the trained model LM to output processing conditions whose reliability can be guaranteed. Specifically, when there is a possibility that the processing conditions acquired from the trained model LM are not optimal, the controller 102 does not enter input data in the trained model LM. The trained model LM can therefore be prevented from outputting processing conditions whose reliability cannot be guaranteed. In the present embodiment, the substrate W can be prevented from being processed when processing conditions (scan speed information) to be acquired from the trained model LM are not possibly optimal.

Note that in the present embodiment, the pre-processing thickness is measured but post-processing thickness may be further measured in addition to the pre-processing thickness.

In the present embodiment, the first and second thresholds TH1 and TH2 are set but of the first and second thresholds TH1 and TH2, only the first threshold TH1 may be set.

### [Second Embodiment]

A second embodiment according to the present invention will now be described with reference to FIGS. 1 to 7, 9 to 13, and 15 to 17. However, matters different from those of the first embodiment will be described and description of matters that are the same as those of the first embodiment will be omitted. A condition-setting process (Step S6) in the second embodiment differs from the condition-setting process in the first embodiment.

First, a control device 101 included in a substrate processing apparatus 100 of the present embodiment will be described with reference to FIG. 16. FIG. 16 is a block diagram of the control device 101 included in the substrate processing apparatus 100 of the present embodiment.

As illustrated in FIG. 16, storage 103 further stores predetermined scan speed information SC. The predetermined scan speed information SC exemplifies predetermined conditions. The predetermined scan speed information SC is scan speed information defined in advance.

A controller 102 compares input data and reference data RE and acquires a comparison result. The controller 102 then selects one of a plurality of determination items based on the comparison result and thresholds TH (first threshold TH1 and second threshold TH2).

In the present embodiment, the plurality of determination items further include a fourth determination item. The fourth determination item indicates determining to perform substrate processing based on the predetermined scan speed information SC and also to store, in the storage 103, information indicating that the substrate processing has been performed. A setting screen SE (see the description given with reference to FIG. 11) allows an operator to enter a second determination item or the fourth determination item in a fourth setting field 115.

Note that a first determination item indicates determining not to perform substrate processing. The second determination item indicates determining to perform substrate processing based on processing conditions acquired from a trained model LM and also to cause the storage 103 to store therein flag information indicating that the substrate processing has been performed. A third determination item indicates determining to perform substrate processing based on processing conditions acquired from the trained model LM.

Next, the condition-setting process to be performed by the controller 102 will described with reference to FIG. 17. FIG. 17 is a flow chart depicting the condition-setting process (Step S6). Specifically, FIG. 17 depicts the condition-setting process when the fourth determination item is entered in a fourth setting field 115 of the setting screen SE. The condition-setting process (Step S6) depicted in FIG. 17 further includes Steps S611 and S612 in addition to Steps S61 to S63 depicted in FIG. 14.

The controller 102 starts the condition-setting process (Step S6) and then determines whether or not the flag information indicating that substrate processing has been performed is stored in the storage 103 (Step S611). The flag information indicating that the substrate processing has been performed is stored in the storage 103 in Step S54 depicted in FIG. 13.

If determining that the flag information is stored in the storage 103 (Yes in Step S611), the controller 102 sets, in recipe data RP, respective scan speeds at speed-indicating positions based on the predetermined scan speed information SC (Step S612). The condition-setting process (Step S6) then ends and a process step to be performed by the controller 102 proceeds to Step S7 (see the description given with reference to FIG. 12).

If determining that the flag information is not stored in the storage 103 (No in Step S611), the controller102 performs each process step of Steps S61 to S63 described with reference to FIG. 14. The condition-setting process (Step S6) then ends and a process step to be performed by the controller 102 proceeds to Step S7 (see the description given with reference to FIG. 12).

The second embodiment according to the present invention has been described above with reference to FIGS. 1 to 7, 9 to 13, and 15 to 17. This approach by the present embodiment enables the trained model LM to output processing conditions whose reliability can be guaranteed, like the first embodiment.

It is assumed that input data is entered in the trained model LM when a first Euclidean distance is equal to or less than a first threshold TH1 and greater than a second threshold TH2. In this case, there is a slight possibility that the trained model LM will output unexpected scan speed information, as already described. In contrast, the approach of the present embodiment makes it possible to set, in recipe data RP, respective scan speeds at the speed-indicating positions based on the predetermined scan speed information SC when the first Euclidean distance is equal to or less than the first threshold TH1 and greater than a second threshold TH2. It is therefore possible to prevent unexpected scan speeds from being set in the recipe data RP when the first Euclidean distance is equal to or less than the first threshold TH1 and greater than the second threshold TH2.

### [Third embodiment]

A third embodiment according to the present invention will now be described with reference to FIGS. 1 to 11 and 13 to 19. However, matters different from those of the first and second embodiments will be described and description of matters that are the same as those of the first and second embodiments will be omitted. The third embodiment differs from the first and second embodiments in that a controller 102 creates re-training data.

FIG. 18 is a flow chart depicting a process to be performed by a control device 101 (controller 102) of a substrate processing apparatus 100 in the present embodiment. The process depicted in FIG. 18 further includes Steps S10 and S20 in addition to Steps S1 to S9 depicted in FIG. 12.

Note that in the present embodiment, the rotation of a substrate W by a spin motor 4 is not stopped when a drying process (Step S73 in FIG. 15) ends. For example, after the drying process, the controller 102 reduces the rotation speed of the substrate W to the rotation speed during an etching process and a rinse process.

After substrate processing is performed (Step S7), the controller 102 determines whether or not flag information indicating that the substrate processing has been performed is stored in storage 103 (Step S10).

If determining that the flag information is stored in the storage 103 (Yes in Step S10), the controller 102 creates re-training data (Step S20). The controller 102 creates the re-training data and subsequently stops the spin motor 4 from rotating the substrate W. The controller 102 then performs Step S8 (see the description given with reference to FIG. 12). The process depicted in FIG. 18 then ends.

If determining that the flag information is not stored in the storage 103 (No in Step S10), the controller 102 stops the spin motor 4 from rotating the substrate W. The controller 102 then performs Step S8 (see the description given with reference to FIG. 12). The process depicted in FIG. 18 then ends.

Next, a process of creating re-training data (Step S20) will be described with reference to FIG. 19 (Step S20). FIG. 19 is a flow chart depicting the process of creating re-training data (Step S20). The process of creating re-training data (Step S20) includes Steps S21 to S23 as illustrated in FIG. 19.

The controller 102 starts the process of creating re-training data (Step S20) and then controls a thickness gauge 8 to cause the thickness gauge 8 to measure the thickness (post-processing thickness) of an object TG included in a substrate W (Step S21).

Specifically, as described with reference to FIG. 3A, the controller 102 controls a probe-moving mechanism 9 to cause the probe-moving mechanism 9 to move an optical probe 81 to a measurement position P (probe-moving process). The controller 102 then causes the thickness gauge 8 to measure the thickness of the object TG (thickness-measuring process). The controller 102 acquires post-processing measurement data based on measurement signals transmitted from a thickness-measuring instrument 85 of the thickness gauge 8. The post-processing measurement data indicates the distribution of the thicknesses (post-processing thickness) of the object TG after substrate processing is performed.

The controller 102 acquires the post-processing measurement data and subsequently acquires processing amounts based on pre-processing measurement data and the post-processing measurement data (Step S22). Specifically, the processing amounts indicate the difference between pre-processing thickness and the post-processing thickness.

The controller 102 acquires the processing amounts and then creates re-training data (Step S23). The re-training data includes scan speed information and processing amount information, similar to the training data LD described with reference to FIG. 9. The controller 102 creates the re-training data based on respective scan speeds at speed-indicating positions that are set in recipe data RP and the processing amounts.

The controller 102 creates the re-training data and subsequently causes the spin motor 4 to stop rotating the substrate W. The process of creating re-training data (Step S20) then ends and a process step to be performed by the controller 102 proceeds to Step S8 depicted in FIG. 18.

The third embodiment according to the present invention has been described above with reference to FIGS. 1 to 11 and 13 to 19. The approach of the present embodiment enables creation of the re-training data when a first Euclidean distance is equal to or less than a first threshold TH1 and greater than a second threshold TH2. As already described, a value B of the second threshold TH2 is set to a value in a region where the number of training data LD is small. Thus, the re-training data is created when the first Euclidean distance is equal to or smaller than the first threshold TH1 and larger than the second threshold TH2. Therefore, the number of training data LD in an area where the number of training data LD is small can be increased for re-training. As a result, the prediction accuracy of the trained model LM is improved.

Note that in the present embodiment, substrates W of which a first Euclidean distance is equal to or less than the first threshold TH1 and greater than the second threshold TH2 are subjected to re-training but all substrates W that have undergone substrate processing may be subject to re-training. In this case, all substrates W of which a first Euclidean distance is equal to or less than the first threshold TH1 are subjected to re-training.

The re-training data may further include information indicating that a processing amount (etching amount) does not match a target processing amount (target etching amount), or information indicating that a processing amount is not within an allowable range. In this case, the controller 102 determines whether or not a processing amount (etching amount) matches input data (target etching amount). Alternatively, the controller 102 determines whether or not a processing amount is within the allowable range.

### [Fourth embodiment]

A fourth embodiment according to the present invention will now be described with reference to FIGS. 1 to 20. However, matters different from those of the first to third embodiments will be described and description of matters that are the same as those of the first to third embodiments will be omitted. The fourth embodiment differs from the first to third embodiments in that the thickness of an object TG is measured by a device external to a substrate processing apparatus 100.

FIG. 20 is a diagram depicting a substrate processing system 1000 in the present embodiment. As illustrated in FIG. 20, the substrate processing system 1000 in the present embodiment includes the substrate processing apparatus 100 and a film thickness gauge apparatus 200. The film thickness gauge apparatus 200 is an example of a thickness gauge apparatus.

The film thickness gauge apparatus 200 measures the thickness of an object TG included in a substrate W before substrate processing is performed. The substrate processing apparatus 100 performs substrate processing after the film thickness gauge apparatus 200 measures the thickness of the object TG.

Specifically, a controller 102 of the substrate processing apparatus 100 acquires measurement results by the film thickness gauge apparatus 200. For example, the substrate processing apparatus 100 and the film thickness gauge apparatus 200 may be connected in a state that allows both of them to communicate with each other. In this case, data indicating measurement results by the film thickness gauge apparatus 200 may be transmitted from the film thickness gauge apparatus 200 to the substrate processing apparatus 100. The communication medium may be a communication cable or wireless. Alternatively, a medium holding data may be used to cause the controller 102 of the substrate processing apparatus 100 to acquire measurement results by the film thickness gauge apparatus 200. Examples of the medium holding data may include an optical disc such as a compact disc and a DVD and a storage device such as USB memory.

The controller 102 of the substrate processing apparatus 100 acquires pre-processing measurement data from the measurement results by the film thickness gauge apparatus 200. The pre-processing measurement data indicates the distribution of the thickness of an object TG before substrate processing is performed. The controller 102 then operates as described in the first to third embodiments. That is, the controller 102 creates input data based on target data indicating target values (target thickness) for the thickness of the object TG and pre-processing measurement data. The controller 102 then compares the input data and reference data RE to determine whether or not to perform substrate processing.

Note that in the present embodiment, the substrate processing apparatus 100 may or may not include a thickness gauge 8.

The fourth embodiment according to the present invention has been described above with reference to FIGS. 1 to 20. The approach of the present embodiment enables a trained model LM to output processing conditions whose reliability can be guaranteed, like the first to third embodiments.

### [Fifth embodiment]

A fifth embodiment according to the present invention will now be described with reference to FIGS. 1 to 19, 21, and 22. However, matters different from those of the first to fourth embodiments will be described and description of matters that are the same as those of the first to fourth embodiments will be omitted. The fourth embodiment differs from the first to fourth embodiments in that an apparatus external to a substrate processing apparatus 100 determines whether or not to perform substrate processing.

FIG. 21 is a diagram depicting a substrate processing system 1000 in the present embodiment. As illustrated in FIG. 21, the substrate processing system 1000 in the present embodiment includes the substrate processing apparatus 100, a film thickness gauge apparatus 200, and an information processing apparatus 300. The film thickness gauge apparatus 200 is an example of a thickness gauge apparatus. On the other hand, the information processing apparatus 300 is an example of a determining apparatus.

The film thickness gauge apparatus 200 measures the thickness of an object TG included in a substrate W before substrate processing is performed. The information processing apparatus 300 acquires measurement results by the film thickness gauge apparatus 200. For example, the information processing apparatus 300 and the film thickness gauge apparatus 200 may be connected in a state that allows both of them to communicate with each other. In this case, data indicating the measurement results by the film thickness gauge apparatus 200 may be transmitted from the film thickness gauge apparatus 200 to the information processing apparatus 300. The communication medium may be a communication cable or wireless. Alternatively, a medium holding data may be used to cause the information processing apparatus 300 to acquire measurement results by the film thickness gauge apparatus 200. Examples of the medium holding data may include an optical disc such as a compact disc and a DVD and a storage device such as USB memory.

The information processing apparatus 300 determines whether or not to perform substrate processing based on the measurement results by the film thickness gauge apparatus 200. Specifically, the information processing apparatus 300 performs a determining process (see the description given with reference to FIGS. 8 to 11) to determine whether or not to perform substrate processing.

The substrate processing apparatus 100 acquires a determination result and input data from the information processing apparatus 300. The input data is to be entered in a trained model LM. The determination result indicates whether or not to perform substrate processing. For example, the information processing apparatus 300 and the substrate processing apparatus 100 may be connected in a state that allows both of them to communicate with each other. In this case, data indicating the determination result and the input data may be transmitted from the information processing apparatus 300 to the substrate processing apparatus 100. The communication medium may be a communication cable or wireless. Alternatively, a medium holding data may be used to cause the substrate processing apparatus 100 to acquire the determination result and the input data. Examples of the medium holding data may include an optical disc such as a compact disc and a DVD and a storage device such as USB memory.

If performing substrate processing is determined through the information processing apparatus 300, the substrate processing apparatus 100 enters input data in the trained model LM as described in the first to fourth embodiments. The substrate processing apparatus 100 then performs substrate processing based on processing conditions acquired from the trained model LM.

Note that the substrate processing apparatus 100 may acquire input data only when it is determined to perform substrate processing.

Next, a configuration of the information processing apparatus 300 will be described with reference to FIG. 22. FIG. 22 is a block diagram depicting the configuration of the information processing apparatus 300. As illustrated in FIG. 22, the information processing apparatus 300 includes a processing device 301, storage 302, a display device 303, and an input device 304. Examples of the information processing apparatus 300 include a server and a personal computer (PC). The information processing apparatus 300 is however not particularly limited as long as it is a device capable of arithmetic processing.

The processing device 301 includes a processor. Examples of the processing device 301 include a CPU and an MPU. The examples may further include a general-purpose arithmetic logic unit and a dedicated arithmetic logic unit.

The storage 302 stores data and computer programs. The data contains reference data RE. In the present embodiment, the data further contains thresholds TH. The processing device 301 performs various arithmetic processing based on the computer programs and the data stored in the storage 302.

The storage 302 includes main memory. Examples of the main memory include semiconductor memory. The storage 302 may further include auxiliary storage. Examples of the auxiliary storage include semiconductor memory and a hard disc drive. The storage 302 may still further include removable medium.

The display device 303 presents various kinds of information. In the present embodiment, the display device 303 presents a setting screen SE (see the description given with reference to FIG. 11). Examples of the display device 303 include a liquid crystal display and an organic electroluminescent display.

The input device 304 receives inputs from an operator and outputs various information to the processing device 301. Examples of the input device 304 include input devices such as keyboards, pointing devices, and touch panels. For example, the touch panel may be placed on the display surface of the display device 303 and configure a graphical user interface together with the display device 303.

When the display device 303 presents the setting screen SE, an operator can enter values of first and second thresholds TH1 and TH2 in first and second setting fields 112 and 113 (see the description given with reference to FIG. 11) by operating the input device 304. The operator can also enter operations to be performed by the substrate processing apparatus 100 in third and fourth fields 114 and 115 (see the description given with reference to FIG. 11) by operating the input device 304.

The processing device 301 is an example of a determining section. The processing device 301 acquires pre-processing measurement data from the measurement results by the film thickness gauge apparatus 200 like the controller 102 of each substrate processing apparatus 100 described in the first to fourth embodiments. The pre-processing measurement data indicates the distribution of the thickness of an object TG before substrate processing is performed. The processing device 301 then creates input data based on target data and pre-processing measurement data and compares the input data and the reference data RE to determine whether or not to perform substrate processing. The target data indicates a target value (target thickness) for the thickness of an object TG. Specifically, the processing device 301 compares the input data and the reference data RE to acquire a comparison result and determines whether or not to perform the substrate processing based on the comparison result and the thresholds TH.

The fifth embodiment according to the present invention has been described above with reference to FIGS. 1 to 19, 21, and 22. The approach of the present embodiment enables the trained model LM to output processing conditions whose reliability can be guaranteed, like the first to fourth embodiments.

Embodiments according to the present invention have been described above with reference to the accompanying drawings (FIGS. 1 to 22). However, the present invention is not limited to the above embodiments and may be implemented in various manners with in a scope not departing from the gist thereof. In addition, the plurality of constituent elements disclosed in the above embodiments can be altered as appropriate. For example, some constituent elements among all of the constituent elements illustrated in one embodiment may be added to the constituent elements of another embodiment, or some constituent elements among all of the constituent elements illustrated in one embodiment may be removed from the embodiment.

The drawings illustrate each constituent element mainly in a schematic manner to facilitate understanding of the invention. Aspects such as the thickness, length, number, and interval of each constituent element illustrated in the drawings may differ in practice for convenience of drawing preparation. It also need not be stated that the configuration of each constituent element illustrated in the above embodiments is an example and is not a particular limitation. Various changes can be made without substantially deviating from the effects of the present invention.

For example, in the embodiments described with reference to FIGS. 1 to 22, a clamping type chuck that clamps a substrate W has been described as a configuration for holding the substrate W. The configuration for holding a substrate W is however not particularly limited as long as the substrate W can be held horizontally. For example, a vacuum chuck or a Bernoulli chuck may be employed as a spin chuck 3.

In the embodiments described with reference to FIGS. 1 to 22, the approach thereof enables an operator to set the value of the first threshold TH1. A first threshold TH1 whose value is a predetermined value may however be employed. Similarly, the approach of the embodiments described with reference to FIGS. 1 to 22 enables an operator to set the value of the second threshold TH2. A second threshold TH2 whose value is a predetermined value may however be employed.

In the embodiments described with reference to FIGS. 1 to 22, the approach thereof enables an operator to set the operation of the substrate processing apparatus 100 when the first Euclidean distance is greater than the first threshold TH1. However, a configuration in which a substrate processing apparatus 100 operates according to a predetermined operation when a first Euclidean distance is greater than a first threshold TH1 may be adopted. Similarly, the approach of the embodiments described with reference to FIGS. 1 to 22 enables an operator to set the operation of the substrate processing apparatus 100 when the first Euclidean distance is greater than the second threshold TH2 and less than or equal to the first threshold TH1. However, a configuration in which a substrate processing apparatus 100 operates according to a predetermined operation when a first Euclidean distance is greater than a second threshold TH2 and less than or equal to a first threshold TH1 may be adopted.

In the embodiments described with reference to FIGS. 1 to 22, the thresholds TH include two thresholds (first threshold TH1 and second threshold TH2). However, a configuration in which thresholds TH include there or more thresholds may be adopted.

In the embodiments described with reference to FIGS. 1 to 22, a Euclidean distance (first Euclidean distance) is calculated by comparing the reference data RE and the input data. However, a configuration in which a degree of similarity between reference data RE and input data is calculated by comparing the reference data RE and the input data may be adopted. Specifically, the degree of similarity between the reference data RE and the input data may be calculated by dynamic time warping (DTW) or derivative DTW (DDTW). In this case, a degree of similarity between processing amounts of training data LD and the reference data RE is calculated by DTW or DDTW instead of a Euclidean distance (second Euclidean distance) between the processing amounts of the training data LD and the reference data RE.

In the embodiments described with reference to FIGS. 1 to 22, an operator is informed of errors by the display device 104 presenting error screens but errors to be informed are not limited to the presenting error screens. For example, a configuration in which a substrate processing apparatus 100 include a speaker may be adopted. In this case, a controller 102 may cause the speaker to emit an error sound. An alternative configuration in which a substrate processing apparatus 100 include a lamp may be adopted. In this case, a controller 102 may blink the lamp or turn on the lamp to notify an operator of errors.

In the embodiments described with reference to FIGS. 1 to 22, the scan speed information indicates respective scan speeds at speed-indicating positions. However, a configuration in which scan speed information indicates only one set value of scan speed may be adopted. In this case, a first nozzle 51 moves at a constant speed from a start position to tan end position in the movement range of the first nozzle 51.

In the embodiments described with reference to FIGS. 1 to 22, the moving speed of the first nozzle 51 is set. However, a configuration in which a relative moving speed between a first nozzle 51 and a substrate W is set may be adopted. Note that when the substrate W rotates, the relative moving speed between the first nozzle 51 and the substrate W indicates a relative moving speed between the first nozzle 51 and the surface of the substrate W that is rotating. For example, the relative moving speed indicates the sum of the speed component (vector) of the first nozzle 51 and the speed component (vector) of the portion, of the substrate W that is rotating, facing the first nozzle 51. Here, the speed component of the substrate W indicates the speed in the circumferential direction CD.

In the embodiments described with reference to FIGS. 1 to 22, the first nozzle 51 turns. However, a configuration in which a first nozzle 51 moves linearly may be adopted.

In the embodiments described with reference to FIGS. 1 to 22, the first nozzle 51 is a scan nozzle. However, a configuration in which a first nozzle 51 is a fixed nozzle may be adopted. In this case, each processing unit 1 includes a substrate-moving mechanism that moves a substrate W instead of the abovementioned nozzle-moving mechanism 6. Recipe data RP contains moving speeds of the substrate W instead of scan speeds. In this case, a trained model LM outputs substrate speed information indicating moving speeds of a substrate W. A controller 102 controls the substrate-moving mechanism based on the substrate speed information. The substrate speed information may indicate a moving speed of the substrate W that is set for each of positions (each substrate position) that divides the movement range in which the substrate W moves into a plurality of sections, like the scan speed information. Note that the substrate W may turn or linearly move.

In the embodiments described with reference to FIGS. 1 to 22, only the first nozzle 51 moves while the substrate W is processed. However, a configuration in which a first nozzle 51 and a substrate W move may be adopted. In this case, each processing unit 1 further includes a substrate-moving mechanism that moves a substrate W in addition to the nozzle-moving mechanism 6. Recipe data RP contains moving speeds of a substrate W that are set together with scan speeds. In this case, a trained model LM outputs substrate speed information that defines the moving speeds of the substrate W in addition to scan speed information. A controller 102 controls the substrate-moving mechanism based on the substrate speed information.

In the embodiments described with reference to FIGS. 1 to 22, the optical probe 81 is fixed at the measurement position P (fixed position) when measuring the thickness of an object TG. However, a configuration in which an optical probe 81 moves when measuring the thickness of an object TG may be adopted. In this case, the optical probe 81 moves so that a measurement position of the thickness of the object TG forms a track TJ1 having a shape like an arc in plan view as illustrated in FIG. 3A.

Specifically, when measuring the thickness of the object TG, the optical probe 81 emits light toward the object TG while moving between a central portion CT and an edge portion EG of the substrate W in a plan view. The thickness of the object TG is measured at each measurement position included in the track TJ1. The measurement positions correspond to radius positions of the substrate W. Therefore, the distribution of the thickness of the object TG included in the substrate W in the radial direction thereof is measured by a thickness-measuring process.

In the embodiments described with reference to FIGS. 1 to 22, the trained model LM outputs the scan speed information as an objective variable. However, a configuration in which a trained model LM outputs other processing conditions that affect processing amounts instead of or in addition to the scan speed information may be adopted. For example, the trained model LM may output at least one of other processing conditions whose examples include rotation speeds of a substrate W, chemical liquid temperature, chemical liquid concentration, and discharge flow rates of chemical liquids.

In the embodiments described with reference to FIGS. 1 to 22, the chemical liquid is an etchant but the chemical liquid is not limited to the etchant. Any liquid that processes a substrate W may be employed as a chemical liquid. For example, the chemical liquid may be a removal liquid that removes an object TG. By using the removal liquid, it is possible to perform a process of removing a specific film or a process of removing a specific film in which foreign matter is mixed. When the substrate W is subjected to a process of removing resist, the removal liquid is, for example, a sulfuric acid/hydrogen peroxide mixture (SPM). The process of removing resist is a process of removing a resist from the surface of a semiconductor substrate.

In the embodiments described with reference to FIGS. 1 to 22, a process of substrate processing includes an etching process but the process of substrate processing is not limited to the etching process. For example, a process of substrate processing may include a deposition process. When a substrate processing apparatus 100 performs the deposition process, a processing liquid is, for example, SPM or ozone water. In this case, an oxide film is formed on a substrate W. A processing amount indicates an amount of the film formed.

In the embodiments described with reference to FIGS. 1 to 22, the substrate processing apparatus 100 is a single-wafer type apparatus that performs substrate processing for each substrate W. A configuration in which a substrate processing apparatus 100 is a batch type apparatus that processes a plurality of substrates W simultaneously may be adopted.

### INDUSTRIAL APPLICABILITY

The present invention is useful in the field of processing substrates.

### REFERENCE SIGNS LIST

- 6: Nozzle-moving mechanism
- 8: Thickness gauge
- 51: First nozzle
- 100: Substrate processing apparatus
- 102: Controller
- 103: Storage
- 104: Display device
- 111: Graph display field
- 112: First setting field
- 113: Second setting field
- 114: Third setting field
- 115: Fourth setting field
- 200: Film thickness gauge apparatus
- 300: Information processing apparatus
- 301: Processing device
- 302: Storage
- 1000: Substrate processing system
- GR: Graph
- LD: Training data
- LM: Trained model
- RE: Reference data
- SC: Predetermined scan speed information
- SE: Setting screen
- TG: Object
- TH: Threshold
- TH1: First threshold
- TH2: Second threshold
- W: Substrate

## Claims

1. A substrate processing apparatus that performs substrate processing that is processing of a substrate, comprising:
a thickness gauge that measures thickness of an object included in the substrate;
a controller that enters input data in a trained model, which outputs processing conditions when the substrate processing is performed, to cause the trained model to output the processing conditions, the input data indicating a target value for a processing amount by the substrate processing;
storage that stores reference data acquired based on pieces of training data used to construct the trained model, wherein
the training data indicates a processing amount by the substrate processing during training, and
the controller:
causes the thickness gauge to measure the thickness of the object before the substrate processing is performed and then acquires pre-processing measurement data indicating the thickness of the object before the substrate processing is performed;
creates the input data based on the pre-processing measurement data and target data indicating a target value for the thickness of the object; and
compares the input data and the reference data to determine whether or not to perform the substrate processing.

2. The substrate processing apparatus according to claim 1, wherein
the storage stores at least one threshold for a comparison result between the input data and the reference data, and
the controller compares the input data and the reference data to acquire a comparison result, and then determines whether or not to perform the substrate processing based on the comparison result and the at least one threshold.

3. The substrate processing apparatus according to claim 2, wherein the controller selects one of a plurality of determination items based on the comparison result and the at least one threshold, wherein
the plurality of determination items includes:
a first determination item that indicates determining not to perform the substrate processing;
a second determination item that indicates determining to perform the substrate processing based on the processing conditions acquired from the trained model, and also to cause the storage to store therein information indicating that the substrate processing has been performed; and
a third determination item that indicates determining to perform the substrate processing based on the processing conditions acquired from the trained model.

4. The substrate processing apparatus according to claim 3, wherein
the at least one threshold includes a first threshold and a second threshold less than the first threshold, and
the controller:
selects the first determination item when the comparison result is greater than the first threshold;
selects the second determination item when the comparison result is greater than the second threshold and less than or equal to the first threshold; and
selects the third determination item when the comparison result is equal to or less than the second threshold.

5. The substrate processing apparatus according to claim 3, wherein
the storage further stores predetermined conditions as the processing conditions, and
the plurality of determination stepsitems further includes a fourth determination item that indicates determining to perform the substrate processing based on the predetermined conditions, and also to cause the storage to store therein information indicating that the substrate processing has been performed.

6. The substrate processing apparatus according to claim 5, wherein
the at least one threshold includes a first threshold and a second threshold less than the first threshold, and
the controller:
selects the first determination item when the comparison result is greater than the first threshold;
selects the second determination item or the fourth determination item when the comparison result is greater than the second threshold and less than or equal to the first threshold; and
selects the third determination item when the comparison result is equal to or less than the second threshold.

7. A substrate processing apparatus according to any one of claims 2 to 6, further comprising a display device that presents a setting screen, wherein
the setting screen includes a setting field that is allowed to set the at least one threshold in.

8. A substrate processing apparatus according to any one of claims 3 to 6, further comprising a display device that presents a setting screen, wherein the setting screen includes a first setting field that, for the at least one threshold, is allowed to set one determination item in, the one determination item being one of the plurality of determination items.

9. The substrate processing apparatus according to claim 8, wherein the setting screen further includes a second setting field that is allowed to set the at least one threshold in.

10. A substrate processing apparatus according to any one of claims 7 to 9, wherein the setting screen further includes a graph display field that presents a graph in which the pieces of training data is quantified.

11. The substrate processing apparatus according to claim 10, wherein the setting screen presents the at least one threshold in the graph display field.

12. A substrate processing apparatus according to any one of claims 1 to 11, further comprising a nozzle that discharges a processing liquid toward the substrate, wherein a process of the substrate processing includes a process of discharging the processing liquid from the nozzle toward the substrate.

13. The substrate processing apparatus according to claim 12, further comprising a nozzle-moving mechanism that cause the nozzle to move when the substrate processing is performed.

14. The substrate processing apparatus according to claim 13, wherein the processing conditions include a moving speed of the nozzle.

15. A substrate processing apparatus according to any one of claims 12 to 14, wherein the processing liquid includes an etchant that etches the object.

16. A substrate processing system that comprises a thickness gauge apparatus that measures thickness of an object included in a substrate and a substrate processing apparatus that performs substrate processing, which is processing of the substrate, after the thickness gauge apparatus measures the thickness of the object, the substrate processing apparatus including:
a controller that enters input data in a trained model, which outputs processing conditions when the substrate processing is performed, to cause the trained model to output the processing conditions, the input data indicating a target value for a processing amount by the substrate processing; and
storage that stores reference data acquired based on pieces of training data used to construct the trained model, wherein
the training data indicates a processing amount by the substrate processing during training, and
the controller:
acquires pre-processing measurement data from measurement results by the thickness gauge apparatus, the pre-processing measurement data indicating the thickness of the object before the substrate processing is performed;
creates the input data based on the pre-processing measurement data and target data indicating a target value for the thickness of the object; and
compares the input data and the reference data to determine whether or not to perform the substrate processing.

17. A substrate processing system comprising:
a thickness gauge apparatus that measures thickness of an object included in a substrate;
a determining apparatus that determines whether or not to perform substrate processing, which is processing of the substrate; and
a substrate processing apparatus that causes a trained model, which outputs processing conditions when the substrate processing is performed, to output the processing conditions to perform the substrate processing, wherein
the determining apparatus includes
storage that stores reference data acquired based on pieces of training data used to construct the trained model,
a determining device that determines whether or not to perform the substrate processing,
the training data indicates a processing amount by the substrate processing during training,
the determining device:
acquires pre-processing measurement data from measurement results by the thickness gauge apparatus, the pre-processing measurement data indicating the thickness of the object before the substrate processing is performed;
creates input data based on target data and the pre-processing measurement data, the input data indicating a target value for a processing amount by the substrate processing, the target data indicating a target value for the thickness of the obj ect;
compares the input data and the reference data to determine whether or not to perform the substrate processing,
the substrate processing apparatus includes a controller that, when the determining apparatus determines to perform the substrate processing, enters the input data in the trained model to cause the trained model to output the processing conditions.

18. A data processing method, comprising:
measuring thickness of an object included in a substrate before substrate processing is performed to acquire pre-processing measurement data indicating measurement results of the thickness of the object;
creating input data based on target data and the pre-processing measurement data, the input data indicating a target value for a processing amount by the substrate processing, the target data indicating a target value for the thickness of the object; and
comparing reference data and the input data to determine whether or not to perform the substrate processing, the reference data being acquired based on pieces of training data used to construct a trained model, wherein
the training data indicates a processing amount by the substrate processing during training,
the trained model outputs, in response to the input data being entered therein, processing conditions when the substrate processing is performed.
